# EUROPÄISCHE PATENTSCHRIFT

(11) **EP 3 629 478 B1**
(45) Veröffentlichungstag und Bekanntmachung des Hinweises auf die Patenterteilung: **27.04.2022**
(21) Anmeldenummer: 19197929.3
(22) Anmeldetag: 18.09.2019
(51) Int. Cl.: H03K 17/96

(54) **SENSORVORRICHTUNG ZUR DETEKTION EINER AKTIVIERUNGSHANDLUNG BEI EINEM FAHRZEUG**
SENSOR DEVICE FOR DETECTION OF ACTIVATION IN A VEHICLE
DISPOSITIF CAPTEUR PERMETTANT DE DÉTECTER UN TRAITEMENT D'ACTIVATION SUR UN VÉHICULE

(30) Priorität: 26.09.2018 DE 102018123736; 07.12.2018 DE 102018131379
(43) Veröffentlichungstag der Anmeldung: 01.04.2020
(73) Patentinhaber: Huf Hülsbeck & Fürst GmbH & Co. KG, 42551 Velbert (DE)
(72) Erfinder: SIEG, Berthold, 46240 Bottrop (DE); STAHL, Daniel, 31515 Wunstorf (DE); ZIEGLER, Alexander, 42489 Wülfrath (DE); WICKERT, Pascal, 46049 Oberhausen (DE)
(74) Vertreter: Bals & Vogel Patentanwälte PartGmbB

(56) Entgegenhaltungen:
- EP-A2- 2 711 488
- WO-A1-03/071067
- DE-A1-102011 078 077
- FR-A1- 3 055 347
- US-A1- 2011 254 570

## Beschreibung

Die vorliegende Erfindung betrifft eine Sensorvorrichtung zur Detektion einer Aktivierungshandlung bei einem Fahrzeug. Ferner bezieht sich die Erfindung auf einen Türgriff mit der Sensorvorrichtung.

Aus den Schriften EP 2 711 488 A2 und DE 10 2011 078077 A1 sind herkömmliche Vorrichtungen bekannt.

Es ist aus dem Stand der Technik bekannt, dass kapazitive Sensoren bei einem Fahrzeug zur Überwachung einer Annäherung eingesetzt werden. Ein solcher kapazitiver Sensor kann bspw. in einem Türgriff des Fahrzeuges montiert sein, um die Annäherung einer Hand eines Bedieners des Fahrzeuges zu erfassen.

So kann bspw. das Auflegen der Hand an eine Außenseite des Türgriffs dazu führen, dass das Fahrzeug entriegelt oder verriegelt wird.

Ebenfalls ist es denkbar, dass weitere Elektronikkomponenten am Fahrzeug und insbesondere im Türgriff montiert sind. Diese dienen bspw. dazu, eine Kommunikation durchzuführen. So kann bspw. eine NFC-Elektronik ebenfalls im Türgriff dazu genutzt werden, eine Authentifizierung zum Entriegeln des Fahrzeuges bereitzustellen.

Allerdings hat es sich hierbei als Nachteil herausgestellt, dass die Detektion der Annäherung ggf. durch eine weitere Elektronik des Fahrzeuges und insbesondere des Türgriffes gestört werden kann. Insbesondere ist die Überwachung eines Eingreifens in eine Türgriffmulde noch problematisch, da diese von der Elektronik und insbesondere von einer NFC-Antenne ggf. gestört wird. Auch kann umgekehrt, ggf. die Kommunikation durch die kapazitive Erfassung gestört sein.

Es ist daher eine Aufgabe der vorliegenden Erfindung, die voranstehend beschriebenen Nachteile zumindest teilweise zu beheben. Insbesondere ist es eine Aufgabe der vorliegenden Erfindung, eine verbesserte und/oder robustere Überwachung am Fahrzeug und insbesondere im Bereich eines Türgriffes, bereitzustellen.

Die voranstehende Aufgabe wird gelöst durch eine Sensorvorrichtung mit den Merkmalen des unabhängigen Vorrichtungsanspruchs und durch einen Türgriff mit den Merkmalen des Weiteren unabhängigen Vorrichtungsanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Sensorvorrichtung beschrieben sind, selbstverständlich auch im Zusammenhang mit dem erfindungsgemäßen Türgriff, und jeweils umgekehrt, so dass bezüglich der Offenbarung zu den einzelnen Erfindungsaspekten stets wechselseitig Bezug genommen wird bzw. werden kann.

Die Aufgabe wird insbesondere gelöst durch eine (vorzugsweise elektronische) Sensorvorrichtung zur Detektion wenigstens einer Aktivierungshandlung bei einem Fahrzeug, insbesondere für einen (bevorzugt Außen-) Türgriff des Fahrzeuges, aufweisend wenigstens eine der nachfolgenden Komponenten:
- eine (insbesondere elektronische) Leiterplattenanordnung, vorzugsweise mit mehreren Lagen (Leiterplatten-Lagen oder Ebenen)
- wenigstens eine (insbesondere elektronische) Verarbeitungsvorrichtung, z. B. einen Mikrocontroller und/oder integrierten Schaltkreis, welche vorzugsweise in einem Mittenbereich der Leiterplattenanordnung angeordnet ist,
- wenigstens ein (insbesondere elektrisch leitfähiges) Kantensensorelement, welches vorzugsweise in einem zum Mittenbereich angrenzenden Randbereich der Leiterplattenanordnung zur kapazitiven Erfassung angeordnet ist, um zumindest teilweise die Detektion (der Aktivierungshandlung) bereitzustellen,
- wenigstens ein Abschirmelement, welches vorzugsweise sich zwischen dem wenigstens einen Kantensensorelement und dem Mittenbereich erstreckt.

Das Kantensensorelement hat dabei den Vorteil, dass zuverlässig ein Randbereich der Sensorvorrichtung und insbesondere im montierten Zustand ein Randbereich des Türgriffs überwacht werden kann. Dies kann die Detektion der Aktivierungshandlung verbessern, wenn die Aktivierungshandlung z. B. ein Eingreifen in eine Türgriffmulde umfasst. Auch kann auf diese Weise ermöglicht werden, dass verschiedene Aktivierungshandlungen voneinander zuverlässiger unterschieden werden können. Eine erste Aktivierungshandlung ist dabei bspw., das Berühren und/oder Annähern an den Randbereich und/oder ein Eingreifen in eine Türgriffmulde. Eine zweite Aktivierungshandlung ist bspw. das Berühren und/oder Annähern an eine Außenseite und/oder an einen Seitenbereich (bzw. Mittenbereich) der Sensorvorrichtung bzw. des Türgriffs. Den verschiedenen Aktivierungshandlungen können dabei auch verschiedene Funktionen zugeordnet sein, wie z. B. das Entriegeln des Fahrzeuges und das Verriegeln des Fahrzeuges. Die Detektion der jeweiligen Aktivierungshandlung kann dabei zur Aktivierung der entsprechenden Funktion führen, z. B. durch eine Ansteuerung einer Fahrzeugelektronik mittels der Verarbeitungsvorrichtung. Um die Detektion und/oder Aktivierung bereitzustellen, kann die Verarbeitungsvorrichtung z. B. elektrisch mit dem wenigstens einen Kantensensorelement verbunden sein. Auf diese Weise kann die Verarbeitungsvorrichtung gemeinsam mit dem wenigstens einen Kantensensorelement eine kapazitive Sensorik bereitstellen.

Um die kapazitive Erfassung bereitzustellen, kann es vorteilhafterweise vorgesehen sein, dass die wenigstens eine Verarbeitungsvorrichtung mit dem wenigstens einen Kantensensorelement elektrisch verschaltet ist. Die Verarbeitungsvorrichtung kann z. B. dazu ausgeführt sein, eine Kapazitätsveränderung des wenigstens einen Kantensensorelements auszuwerten. Diese Kapazitätsveränderung wird bspw. durch eine Umgebung des Kantensensorelements hervorgerufen, wie z. B. durch eine Annäherung an das Kantensensorelement durch eine Hand oder dergleichen eines Bedieners des Fahrzeuges. Die Kapazitätsveränderung kann z. B. durch wiederholt durchgeführte Ladungsverschiebungen von dem Kantensensorelement an die Verarbeitungsvorrichtung und/oder einem der Verarbeitungsvorrichtung vorgeschalteten Kondensator ausgewertet werden. Die auf diese Weise übertragene Ladung von dem Kantensensorelement und/oder die mittels mehrerer Ladungsübertragungen auf akkumulierte Ladung kann dabei als Maß für die Kapazität des Kantensensorelements dienen, und z. B. mittels eines Analog-DigitalWandlers messtechnisch erfasst werden. In entsprechender Weise kann z. B. auch wenigstens ein weiteres Sensorelement zur kapazitiven Erfassung bei einer erfindungsgemäßen Sensorvorrichtung ausgewertet werden. Wenn wenigstens ein weiteres Sensorelement und/oder mehrere Kantensensorelemente vorgesehen sind, hat dies den Vorteil, dass ggf. verschiedene Bereiche kapazitiv überwacht werden können.

Da die kapazitive Erfassung ggf. durch äußere Einflüsse, wie z. B. durch eine Elektronik der Sensorvorrichtung und/oder durch die Verarbeitungsvorrichtung, gestört werden kann, ist die Nutzung des wenigstens einen Abschirmelements besonders vorteilhaft. Dieses kann sich insbesondere zwischen dem wenigstens einen Kantensensorelement, welches abgeschirmt werden soll, und dem Bereich mit potentiellen Störungsquellen erstrecken. Dieser Bereich ist bspw. ein Mittenbereich der Sensorvorrichtung, in welchem eine Elektronik und/oder die Verarbeitungsvorrichtung angeordnet sein kann. Der Mittenbereich kann sich dabei (wie auch der Randbereich) ggf. über mehrere Lagen der Leiterplattenanordnung erstrecken. In gleicher Weise kann sich daher auch das Abschirmelement über mehrere Lagen erstrecken, um zuverlässig die Abschirmung bereitzustellen. Die Erstreckung über mehrere Lagen wird bspw. dadurch erzielt, dass ein Abschirmelement einer ersten Lage über eine Durchkontaktierung elektrisch mit einem Abschirmelement einer anderen Lage verbunden ist, sodass sich ein lagenübergreifendes Abschirmelement ausbildet.

Vorteilhaft ist es zudem, wenn das Fahrzeug als ein Kraftfahrzeug, insbesondere als ein Hybridfahrzeug oder als ein Elektrofahrzeug ausgebildet ist, vorzugsweise mit einem Hochvolt-Bordnetz und/oder einem Elektromotor. Außerdem kann es möglich sein, dass das Fahrzeug als ein Brennstoffzellenfahrzeug und/oder Personenkraftfahrzeug und/oder semiautonomes oder autonomes Fahrzeug ausgebildet ist. Vorteilhafterweise weist das Fahrzeug ein Sicherheitssystem auf, welches z. B. durch eine Kommunikation mit einem Identifikationsgeber (ID-Geber) eine Authentifizierung ermöglicht. In Abhängigkeit von der Kommunikation und/oder der Authentifizierung kann wenigstens eine Funktion des Fahrzeuges aktiviert werden. Falls hierzu die Authentifizierung des ID-Gebers notwendig ist, kann es sich bei der Funktion um eine sicherheitsrelevante Funktion handeln, wie ein Entriegeln des Fahrzeuges oder eine Freigabe eines Motorstarts. Somit kann das Sicherheitssystem auch als ein passives Zugangssystem ausgebildet sein, welches ohne aktive manuelle Betätigung des ID-Gebers die Authentifizierung und/oder die Aktivierung der Funktion bei Detektion der Annäherung des ID-Gebers an das Fahrzeug initiiert. Hierzu wird bspw. wiederholt ein Wecksignal durch das Sicherheitssystem ausgesendet, welches durch den ID-Geber bei der Annäherung empfangen werden kann, und dann die Authentifizierung auslöst. Auch kann die Funktion eine Aktivierung einer Fahrzeugbeleuchtung und/oder ein Betätigen (Öffnen und/oder Schließen) einer Klappe (z. B. Front- oder Heck- oder Seitenklappe bzw. -tür) betreffen. Bspw. wird automatisch bei der Detektion der Annäherung die Fahrzeugbeleuchtung aktiviert und/oder bei der Detektion einer Geste eines Benutzers die Klappe betätigt.

Die Detektion der Annäherung und/oder der Geste und/oder die Aktivierung der Funktion kann bspw. zumindest teilweise durch die kapazitive Erfassung einer erfindungsgemäßen Sensorvorrichtung bereitgestellt sein. Entsprechend kann die Aktivierungshandlung auch eine Geste und/oder die Annäherung sein. Eine Auswertung der kapazitiven Erfassung z. B. durch die Verarbeitungsvorrichtung kann dabei dazu dienen, die Detektion durchzuführen (z. B. ein Eingreifen in eine Türgriffmulde zu detektieren anhand der kapazitiven Erfassung) und daraufhin die Funktion zu aktivieren (z. B. ein Wecksignal aussenden und/oder die Entriegelung durchzuführen).

Es kann möglich sein, dass die Leiterplatte als eine mehrlagige (oder auch mehrschichtige oder engl. "Multilayer-") Leiterplatte ausgebildet ist. Auf diese Weise kann der Vorteil erzielt werden, dass die Packungsdichte deutlich erhöht werden kann. In anderen Worten können verschiedene Funktionen durch den Einsatz zusätzlicher Elektronik (wie zur NFC-Kommunikation) bereitgestellt werden. Bspw. können hierzu bei der Leiterplatte mehrere Leiterplatten (die Lagen bzw. Ebenen) mit sogenannten Prepregs (engl. preimpregnated fibres) aufeinander geklebt sein, um die mehrlagige Leiterplatte auszubilden. Die elektrischen Verbindungen zwischen den Lagen werden mit Durchkontaktierungen ("Vias") hergestellt. Um trotz dieser hohen Packungs- und/oder Funktionsdichte eine zuverlässige Erfassung und/oder Kommunikation bereitzustellen, kann vorteilhaftweise wenigstens ein Abschirmelement vorgesehen sein. Eine erfindungsgemäße Anordnung dieser Abschirmelemente z. B. im Randbereich kann eine besonders zuverlässige Abschirmung ermöglichen.

Im Rahmen der Erfindung wird insbesondere unter einer Lage eine Leiterplattenebene (engl. Layer) der Leiterplattenanordnung verstanden, welche z. B. Leiterbahnen und Elektronikkomponenten aufweisen kann.

Es ist denkbar, dass der Mittenbereich und der Randbereich lagenübergreifend definiert und damit für jede Lage der Leiterplattenanordnung gleich ist. In anderen Worten kann somit der Mittenbereich und der Randbereich jeweils als ein Bereich in einer Projektion sämtlicher Lagen der Leiterplattenanordnung auf einer Ebene definiert sein.

Konkret können die verschiedenen Lagen übereinander (d. h. in einer Querrichtung) so angeordnet und/oder gestapelt sein, dass die jeweiligen Randbereiche der Lagen an gleicher Position (in Längs- und/oder Hochrichtung) übereinander liegen. In gleicher Weise können auch die jeweiligen Mittenbereiche der Lagen (in Längs- und/oder Hochrichtung) an gleicher Position übereinander liegen.

Bei einer erfindungsgemäßen Sensorvorrichtung können die Richtungsangaben wie folgt anhand der Fahrzeugrichtungen definiert sein, wenn die Ausrichtung der Sensorvorrichtung im am Fahrzeug montierten Zustand, d. h. bspw. im Türgriff einer Seitentür des Fahrzeuges, betrachtet wird. Die Querrichtung ist dann eine Richtung parallel zu einer Fahrzeugquerachse (oder ausgehend von der Sensorvorrichtung in Richtung einer Türgriffmulde), die Längsrichtung eine Richtung parallel zur Fahrzeuglängsachse (oder Fahrtrichtung oder entgegengesetzte Fahrtrichtung bzw. in Richtung der längsten Erstreckung des Türgriffs) und die Hochrichtung eine Richtung parallel zur Fahrzeughochachse. Um die Angaben im Rahmen dieser Erfindung zu vereinfachen, wird auch für eine nicht im Türgriff und/oder an der Seitentür montierten Sensorvorrichtung die voranstehende Definition beibehalten. In anderen Worten kann sich bei einer im Heckbereich des Fahrzeuges z. B. an einer Heckklappe montierten Sensorvorrichtung die Längsrichtung auf die gleiche Richtung der Sensorvorrichtung beziehen, die bei einer potentiellen Anordnung an der Seitentür vorliegen würde. Im Heckbereich ist diese Richtung entsprechend die Fahrzeugquerrichtung, und im Seitenbereich an der Seitentür die Fahrzeuglängsrichtung. Alternativ oder zusätzlich kann die jeweilige Richtung auch funktional definiert sein, sodass die Längsrichtung der Sensorvorrichtung immer orthogonal zu einer Richtung ist, in welche ein Eingreifen in eine Türgriffmulde erfolgt. Entsprechend kann die Hochrichtung parallel zu dieser Richtung des Eingreifens sein.

Bei einem erfindungsgemäßen Türgriff mit der erfindungsgemäßen Sensorvorrichtung (d. h. im montierten Zustand) kann daher das wenigstens eine Kantensensorelement sich zumindest überwiegend parallel zur Längsseite des Türgriffs in Längsrichtung erstrecken, insbesondere entlang einer oberen bzw. unteren Kante des Türgriffs. Die obere und untere Kante können in der Hochrichtung gegenüberliegend angeordnet sein, und sich ggf. in Längsrichtung parallel zueinander erstrecken. Das wenigstens eine Kantensensorelement kann somit z. B. aufgrund der beschriebenen Anordnung geeignet sein, das Eingreifen in eine Türgriffmulde zu überwachen. Hingegen kann eine Anordnung der Lagen in Querrichtung derart erfolgen, dass eine erste Lage näher Richtung Fahrzeugtür und/oder Fahrzeuginnenraum und/oder Türgriffmulde angeordnet ist, und eine letzte (z. B. vierte Lage) entfernter davon bzw. näher an einer Türgriffaußenseite angeordnet ist. Ferner kann eine zweite Lage näher an der ersten Lage angeordnet sein als eine dritte oder die vierte Lage. Die dritte Lage kann zwischen der zweiten und vierten Lage angeordnet sein.

Von weiterem Vorteil kann vorgesehen sein, dass das wenigstens eine Kantensensorelement als wenigstens ein erstes Kantensensorelement und wenigstens ein zweites Kantensensorelement ausgeführt ist, wobei das jeweils erste Kantensensorelement in einem ersten Randbereich der Leiterplattenanordnung und das jeweils zweite Kantensensorelement in einem vom ersten Randbereich gegenüberliegenden zweiten Randbereich angeordnet ist, um vorzugsweise die Detektion bei gegenüberliegenden Kanten des Türgriffs (im montierten Zustand) bereitzustellen. Es kann bspw. pro Lage der Leiterplattenanordnung oder alternativ auf zwei Lagen der Leiterplattenanordnung jeweils ein erstes Kantensensorelement und jeweils ein zweites Kantensensorelement angeordnet sein. Ferner können die ersten Kantensensorelemente miteinander elektrisch verbunden sein, und/oder die zweiten Kantensensorelemente miteinander elektrisch verbunden sein. Optional können die ersten Kantensensorelemente von den zweiten Kantensensorelementen elektrisch entkoppelt sein, oder alternativ ebenfalls elektrisch miteinander verbunden sein. Bevorzugt weisen elektrisch miteinander verbundene Kantensensorelemente und/oder die ersten Kantensensorelemente ein gleiches elektrisches Potential auf. Auch können die zweiten Kantensensorelemente ein gleiches elektrisches Potential aufweisen. Bevorzugt werden zur kapazitiven Erfassung die ersten Kantensensorelemente gemeinsam ausgewertet, z. B. durch eine Ladungsübertragung der in den ersten Kantensensorelementen gemeinsam gespeicherten Ladung. Gleichzeitig kann dies für die zweiten Kantensensorelemente gelten. Bevorzugt wird das wenigstens eine erste Kantensensorelement separat und/oder unabhängig und/oder zeitlich versetzt von dem wenigstens einen zweiten Kantensensorelement zur kapazitiven Erfassung ausgewertet, z. B. durch eine jeweilige Ladungsübertragung von dem jeweiligen Kantensensorelement. Auf diese Weise kann z. B. eine Annäherung an den ersten Randbereich zuverlässig von einer Annäherung an den zweiten Randbereich unterschieden werden. Dies ermöglicht zudem eine zuverlässige Unterscheidung eines Eingreifens in eine Türmulde von oben (also z. B. vom ersten Randbereich aus) und von unten (d. h. z. B. vom zweiten Randbereich aus). Der erste und zweite Randbereich können somit in einer Fahrzeughochachse gegenüberliegend angeordnet sein.

Es ist ferner denkbar, dass das wenigstens eine Kantensensorelement als wenigstens ein erstes Kantensensorelement und wenigstens ein zweites Kantensensorelement ausgeführt ist, wobei die Kantensensorelemente symmetrisch zueinander angeordnet sind. Bspw. kann das erste Kantensensorelement symmetrisch zum zweiten Kantensensorelement sich an der Leiterplattenanordnung erstrecken. Insbesondere erstrecken sich die Kantensensorelemente in zwei gegenüberliegenden Randbereichen der Leiterplattenanordnung symmetrisch und vorzugsweise spiegelsymmetrisch zueinander.

Ebenfalls ist es denkbar, dass (z. B. bei einer Montage der Sensorvorrichtung in einen Türgriff) selektiv wenigstens eins von dem wenigstens einen Sensorelement ausgewählt wird. Z. B. kann je nach Einbaulage der Sensorvorrichtung und/oder des Türgriffs mit der Sensorvorrichtung entweder ein erstes Kantensensorelement oder ein zweites Kantensensorelement genutzt werden und entsprechend ausgewählt bzw. aktiviert werden. Das bei dieser Auswahl nicht ausgewählte Kantensensorelement kann entsprechend deaktiviert und/oder funktionslos geschaltet und/oder zur Bereitstellung einer anderen Funktion umgeschaltet werden. Bei einer Deaktivierung kann z. B. auch eine Umschaltung des nicht ausgewählten Kantensensorelements dadurch erfolgen, dass dem nicht ausgewählten Kantensensorelement eine andere Funktion zugeordnet wird (z. B. die Bereitstellung einer Abschirmung, d. h. eines Shields, und/oder zumindest eines Teils einer Bluetooth-Antenne). Dies hat den Vorteil, dass ein gleicher Aufbau der Sensorvorrichtung auf unterschiedliche Einbaulagen bereitgestellt werden kann.

Es ist ferner denkbar, dass eine Elektronik und/oder die Verarbeitungsvorrichtung der Sensorvorrichtung eine Deaktivierungskomponente aufweist, um zumindest das wenigstens eine Kantensensorelement (insbesondere dauerhaft) zu deaktivieren und/oder funktionslos zu schalten. Bspw. kann diese Deaktivierungskomponente in Abhängigkeit von einer Montage und/oder Einbaulage bei der Montage konfiguriert werden, um nur wenigstens eines des wenigstens einen Kantensensorelements (z. B. nur ein erstes von zwei Kantensensorelementen) auszuwählen.

Gemäß einer vorteilhaften Weiterbildung der Erfindung kann vorgesehen sein, dass das wenigstens eine Kantensensorelement jeweils als langestreckte Elektrode ausgebildet ist, insbesondere in der Form einer Leiterbahn der Leiterplattenanordnung. In anderen Worten kann das wenigstens eine Kantensensorelement als eine elektrisch leitfähige Fläche ausgebildet sein, welche somit äußeren Einflüssen (wie z. B. einer Annäherung) ausgesetzt ist. In Abhängigkeit von diesen Einflüssen kann sich z. B. eine veränderliche Kapazität bei dem wenigstens einen Kantensensorelement ausbilden, welche für die Umgebung des wenigstens einen Kantensensorelements spezifisch ist. Auf diese Weise kann eine zuverlässige Detektion- oder Aktivierungshandlung in der Umgebung des Kantensensorelements bereitgestellt werden.

Weiter ist im Rahmen der Erfindung denkbar, dass die Leiterplattenanordnung als eine mehrlagige Leiterplatte ausgebildet ist, sodass die Leiterplattenanordnung wenigstens zwei oder wenigstens oder genau vier oder wenigstens sechs Lagen aufweist, wobei vorzugsweise zumindest zwei der Lagen jeweils wenigstens eines des wenigstens einen Kantensensorelements aufweisen, welche bevorzugt zumindest teilweise über Durchkontaktierungen miteinander elektrisch verbunden sind, wobei besonders bevorzugt die zumindest zwei der Lagen jeweils das erste Kantensensorelement und das zweite Kantensensorelement aufweisen. Dies hat den Vorteil, dass die kapazitive Erfassung technisch vereinfacht ausgedrückt nicht nur eindimensional pro Kantensensorelement sich auf eine Ebene der Leiterplattenanordnung erstrecken kann, sondern zweidimensional eine Fläche in Hoch- und Längsrichtung zur kapazitiven Erfassung genutzt werden kann.

Es kann von Vorteil sein, wenn im Rahmen der Erfindung das wenigstens eine Abschirmelement sich zwischen dem wenigstens einen Kantensensorelement und einer Elektronik im Mittenbereich an der Leiterplattenanordnung erstreckt, um insbesondere das wenigstens eine Kantensensorelement von der Elektronik abzuschirmen und/oder umgekehrt, wobei vorzugsweise die Elektronik zumindest teilweise auf einer gleichen Lage mit dem Abschirmelement und/oder zumindest teilweise auf einer unterschiedlichen Lage zur Verarbeitungsvorrichtung angeordnet ist. Somit kann eine zuverlässige Funktion des jeweiligen Kantensensorelements bereitgestellt werden. Bei der Nutzung mehrerer Kantensensorelemente kann es möglich sein, dass sich ein erstes Abschirmelement zwischen einem ersten Kantensensorelement und dem Mittenbereich bzw. der Elektronik erstreckt, und ein zweites Abschirmelement sich zwischen einem zweiten Kantensensorelement und dem Mittenbereich bzw. der Elektronik erstreckt. Diese Anordnung kann auch für verschiedene Lagen der Leiterplattenanordnung vorgesehen sein. Auch ist es denkbar, dass die Anordnung eines Abschirmelements in Bezug auf ein Kantensensorelement für zwei gegenüberliegende Randbereiche der Leiterplattenanordnung symmetrisch erfolgt.

Vorteilhafterweise kann bei der Erfindung vorgesehen sein, dass das wenigstens eine Kantensensorelement mehrere Kantensensorelemente aufweisen, wobei vorzugsweise die Kantensensorelemente an gegenüberliegenden Randbereichen der Leiterplattenanordnung elektrisch voneinander entkoppelt sind, und an gleichen Randbereichen elektrisch miteinander verbunden sind, insbesondere auch lagenübergreifend über Durchkontaktierungen. Die Durchkontaktierungen (insbesondere Vias) können somit eine zuverlässige elektrische Kontaktierung bewirken, sodass die miteinander elektrisch über die Durchkontaktierungen verbundenen Kantensensorelemente ein gleiches elektrisches Potential aufweisen. Analog hierzu können z. B. auch verschiedene Abschirmelemente und/oder verschiedene Bereiche eines Antennenelementes miteinander verbunden sein.

Gemäß einem weiteren Vorteil kann vorgesehen sein, dass für jedes des wenigstens einen Kantensensorelements ein zugehöriges Abschirmelement vorgesehen ist, welches sich zumindest teilweise oder überwiegend parallel zum jeweiligen Kantensensorelement erstreckt. Bspw. ist das zugehörige Abschirmelement derart angeordnet, dass es eine Abschirmung für das zugehörige Kantensensorelement von einer Elektronik und/oder von einem Mittenbereich der Sensorvorrichtung bewirkt.

Ferner ist es optional vorgesehen, dass wenigstens ein zusätzliches Sensorelement zur kapazitiven Erfassung zumindest teilweise außerhalb eines Randbereichs der Leiterplattenanordnung insbesondere an der Leiterplattenanordnung angeordnet ist, vorzugsweise an einer Lage (Ebene) der Leiterplattenanordnung oder (z. B. als Blech) von der Leiterplattenanordnung getrennt, welche sich von einer Lage mit dem wenigstens einen Kantensensorelement unterschiedet, um vorzugsweise die Detektion zumindest teilweise in einem Seitenbereich und/oder Mittenbereich des Türgriffs bereitzustellen. Dieses zusätzliche Sensorelement kann bspw. für eine Funktion des Fahrzeuges genutzt werden, welche sich von der Funktion des wenigstens einen Kantensensorelements unterscheidet. Die Funktion, welche z. B. durch die Erfassung durch das zusätzliche Sensorelement aktiviert wird, ist bspw. eine Entriegelung oder Verriegelung des Fahrzeuges. Entsprechend ist es sinnvoll, dass hierzu ein Aktivierungsbereich vorgesehen ist, weicher sich von dem Erfassungsbereich des wenigstens einen Kantensensorelements unterscheidet. Das zusätzliche Sensorelement kann bspw. als ein flächiges Sensorelement, insbesondere mit einem Grätenmuster, ausgebildet sein.

Es ist vorgesehen, dass wenigstens ein Antennenelement, vorzugsweise eine NFC-(Near-Field-Communication) Antenne, zumindest teilweise oder überwiegend in einem Randbereich der Leiterplattenanordnung zur Bereitstellung einer kontaktlosen Kommunikation, und ggf. auch zur kontaktlosen Energieübertragung (wie z. B. induktives und/oder kontaktloses Laden) angeordnet ist. Das wenigstens eine Antennenelement kann z. B. zur kontaktlosen Kommunikation, insbesondere Funkkommunikation und/oder NFC-Kommunikation, ausgebildet sein. Diese Kommunikation ermöglicht bspw. eine

Authentifizierung mit einem Identifikationsgeber für das Fahrzeug, d. h. einen Codeaustausch. Jedoch ist es denkbar, dass diese Kommunikation leicht durch eine angrenzende Elektronik (wie z. B. durch das wenigstens eine Kantensensorelement und/oder durch das wenigstens eine Abschirmelement) gestört wird. Daher ist es denkbar, dass das wenigstens eine Antennenelement auf wenigstens einer Lage (Ebene) der Leiterplattenanordnung angeordnet ist, welche sich von der wenigstens einen Lage unterscheidet, auf welcher das wenigstens eine Kantensensorelement angeordnet ist.

Vorzugsweise kann vorgesehen sein, dass wenigstens ein Antennenelement an wenigstens einer oder genau zwei Lagen der Leiterplattenanordnung ausgebildet ist, und sich bevorzugt entlang der gegenüberliegenden Randbereiche der Lage erstreckt, und besonders bevorzugt durch wenigstens eine Durchkontaktierung (elektrisch) verbunden sind, sich über mehrere Lagen erstreckt. Dies hat den Vorteil, dass eine kontaktlose Kommunikation durch das Antennenelement verbessert werden kann. Insbesondere sind dabei die mittels der Durchkontaktierung verbundenen Antennenelemente potentialgleich ausgeführt.

Es kann weiter möglich sein, dass wenigstens ein weiteres Abschirmelement vorgesehen ist, welches sich bspw. zumindest teilweise zwischen einem Antennenelement und einem Rand der Leiterplattenanordnung erstreckt, um insbesondere das Antennenelement von einer Umgebung der Leiterplattenanordnung im Randbereich abzuschirmen und/oder umgekehrt. Das weitere Abschirmelement kann z. B. auch von der Leiterplattenanordnung getrennt angeordnet sein, z. B. als Blech oder dergleichen. Es handelt sich somit hierbei um ein Abschirmelement für das Antennenelement, welches sich entsprechend von dem wenigstens einen Abschirmelement für das wenigstens eine Kantensensorelement unterscheiden kann. Alternativ ist es denkbar, dass auch für das weitere Abschirmelement für das Antennenelement das Abschirmelement für das Kantensensorelement vorgesehen ist.

Auch ist es optional denkbar, dass (wenigstens) eine Anpassung, insbesondere des wenigstens einen Abschirmelements und/oder wenigstens eines weiteren Abschirmelements und/oder des wenigstens einen Kantensensorelements, vorgesehen ist, um insbesondere einen elektrischen Einfluss und/oder eine elektrische Störung wenigstens eines, insbesondere dazu benachbarten, Antennenelements bei der Leiterplattenanordnung zu verringern. Das wenigstens eine Antennenelement kann dabei bspw. das Antennenelement zur kontaktlosen Kommunikation, insbesondere NFC-Kommunikation, sein. Entsprechend kann es sich um eine NFC-Antenne handeln. Um eine Störung dieser Kommunikation zu vermeiden, ist es z. B. notwendig, Wirbelstromverluste zu reduzieren. Hierzu kann die wenigstens eine Anpassung vorgesehen sein. Alternativ oder zusätzlich ist es möglich, dass die Anpassung zur Reduzierung einer davon unterschiedlichen Störung ausgeführt ist, z. B. einer Störung der Kommunikation durch das wenigstens eine Antennenelement oder einer Störung der kapazitiven Erfassung durch das wenigstens eine Antennenelement.

Des Weiteren ist es im Rahmen der Erfindung optional möglich, dass (wenigstens) eine Anpassung lagenübergreifender elektrischer Verbindungen der Leiterplattenanordnung vorgesehen ist, um vorzugsweise Störungen bei wenigstens einem Antennenelement an der Leiterplattenanordnung zu verringern. Hierbei ist ein Gedanke der Erfindung, dass insbesondere die lagenübergreifenden (d. h. Ebenen übergreifenden) elektrischen Verbindungspfade (z. B. des wenigstens einen Kantensensorelements und/oder des wenigstens einen Abschirmelements und/oder des wenigstens einen Antennenelements) eine Störungsquelle darstellen können. Insbesondere können diese lagenübergreifenden elektrischen Verbindungen Schleifen ermöglichen, in denen sich Wirbelströme (z. B. induziert durch das wenigstens eine Antennenelement) ausbilden können. Die wenigstens eine Anpassung kann dazu ausgebildet sein, die Ausbildung der Schleifen und/oder der Wirbelströme zumindest zu reduzieren. Ggf. kann dies auch durch unterschiedlich ausgeführte Anpassungen bereitgestellt werden.

Nach einer weiteren Möglichkeit kann vorgesehen sein, dass (insbesondere als eine erste Art der Anpassung) eine Gitter-Struktur und/oder (insbesondere als eine zweite Art der Anpassung) Schlitze lagenübergreifender elektrischer Verbindungen der Leiterplattenanordnung, insbesondere des wenigstens einen Kantensensorelements, als eine Anpassung vorgesehen sind, sodass vorzugsweise mehrfach redundante Schleifen der Verbindungen lagenübergreifend vorgesehen sind und/oder die Schlitze als mehrere insbesondere randseitige Ausnehmungen der Verbindungen ausgebildet sind, um bevorzugt Störungen bei wenigstens einem und/oder durch wenigstens ein Antennenelement an der Leiterplattenanordnung zu verringern und/oder um eine Entkopplung des wenigstens einen Kantensensorelements von dem wenigstens einen Antennenelement bereitzustellen. Insbesondere die Gitterstruktur bewirkt dabei, dass zwar vermehrt Wirbelströme durch das wenigstens eine Antennenelement induziert werden können, insbesondere wenn die Gitterstruktur schachbrettartig ausgeführt ist, jedoch die Entkoppelung zwischen dem wenigstens einen Antennenelement und dem wenigstens einen Kantensensorelement verbessert wird. Die Nutzung der Schlitze, d. h. insbesondere wiederholt vorgesehener Ausnehmungen der Leiterbahnen, kann hingegen ggf. auch die Wirbelströme reduzieren. Für die Bereitstellung der Gitterstruktur kann es möglich sein, dass sehr viele Durchkontaktierungen zwischen den Kantensensorelementen verschiedener Lagen vorgesehen sind, und durch diese redundanten Durchkontaktierungen redundante Schleifen der elektrischen Verbindung vorhanden sind. Optional kann eine solche Anordnung alternativ oder zusätzlich für das wenigstens eine Abschirmelement als die lagenübergreifenden elektrischen Verbindungen vorgesehen sein.Die lagenübergreifenden elektrischen Verbindungen sind dabei jeweils z. B. als Leiterbahn(en) ausgeführt, welche mittels Durchkontaktierungen miteinander verbunden sein können.

Es ist möglich, dass (insbesondere als eine zweite Art der Anpassung) Schlitze des wenigstens einen Kantensensorelements vorgesehen sein, welche als beabstandet angeordnete wiederholte Ausnehmungen des Kantensensorelements ausgeführt sind. Diese können z. B. kammartig und/oder jeweils rechteckig ausgebildet sein. Dabei können die Schlitze z. B. in Richtung des Randbereichs (insbesondere in Richtung einer Kante) der Leiterplattenanordnung (also kantenseitig) angeordnet und ausgerichtet sein, oder alternativ in Richtung des Mittenbereichs der Leiterplattenanordnung angeordnet und ausgerichtet sein. Alternativ oder zusätzlich können mehrere redundante Durchkontaktierungen des wenigstens einen Kantensensorelements vorgesehen sein, um Kantensensorelemente auf unterschiedlichen Ebenen der Leiterplattenanordnung miteinander elektrisch zu verbinden. Auf diese Weise kann eine Gitter-Struktur (insbesondere als eine erste Art der Anpassung) bereitgestellt werden.

Ferner kann im Rahmen der Erfindung vorgesehen sein, dass wenigstens eine Unterbrechung (insbesondere elektrische Unterbrechung und/oder Entkopplung) des Abschirmelements und/oder eines weiteren Abschirmelements und/oder des wenigstens einen Kantensensorelements als eine Anpassung vorgesehen ist, insbesondere um einen Stromkreis und/oder eine Schleife für einen durch wenigstens ein Antennenelement der Leiterplattenanordnung induzierten Strom, vorzugsweise Wirbelstrom, zu unterbrechen. In anderen Worten können Durchkontaktierungen und/oder Unterbrechungen so gewählt sein, dass die Ausbildung einer Schleife verhindert oder die Anzahl der Schleifen reduziert wird. Bspw. kann die Sensorvorrichtung derart ausgebildet sein, dass bei dem wenigstens einen Abschirmelement und/oder bei dem wenigstens einen weiteren Abschirmelement und/oder bei dem wenigstens einen Kantensensorelement keinerlei Schleifen vorgesehen sind. Die Ausbildung einer Schleife ist bspw. dann verhindert, wenn lagenübergreifend nur ein Pfad über die Durchkontaktierungen vorgesehen ist.

Zudem ist im Rahmen der Erfindung denkbar, dass eine Unterbrechung als eine Anpassung im Bereich wenigstens einer Durchkontaktierung vorgesehen ist, welche das Abschirmelement einer Lage der Leiterplattenanordnung mit dem wenigstens einen Abschirmelement und/oder weiteren Abschirmelementen wenigstens einer weiteren Lage der Leiterplattenanordnung elektrisch verbindet, um eine Schleife dieser Verbindung zu unterbrechen. Bevorzugt ist die Unterbrechung dabei in einer Leiterbahn des Abschirmelements zwischen einer ersten Durchkontaktierung einer Lage und einer davon unmittelbar benachbarten zweiten Durchkontaktierung dieser Lage vorgesehen. Die Unterbrechung ist dabei bspw. als eine Materialausnehmung der Leiterbahn ausgeführt, sodass die Unterbrechung eine elektrische Entkoppelung bewirkt.

Auch ist es möglich, dass eine Unterbrechung als eine Anpassung im Bereich wenigstens einer Durchkontaktierung vorgesehen ist, welche das Kantensensorelement einer Lage der Leiterplattenanordnung mit dem wenigstens einen Kantensensorelement und/oder weiteren Kantensensorelementen wenigstens einer weiteren Lage der Leiterplattenanordnung elektrisch verbindet, um eine Schleife dieser Verbindung zu unterbrechen. Bevorzugt ist die Unterbrechung dabei in einer Leiterbahn des Kantensensorelements zwischen einer ersten Durchkontaktierung einer Lage und einer davon unmittelbar benachbarten zweiten Durchkontaktierung dieser Lage vorgesehen.

Auch kann die Unterbrechung als eine nachträglich hinzugefügte Unterbrechung vorgesehen sein. In anderen Worten kann im Montageverfahren nachträglich eine Leiterbahn unterbrochen werden, um die Anpassung zu erhalten.

Bevorzugt hat dabei eine Anpassung und/oder eine Unterbrechung als die Anpassung nur die Funktion der Störungsreduzierung, und keine weitere Funktion hinsichtlich der Schaltungstopologie. In anderen Worten kann die Unterbrechung eine Leiterbahn unterbrechen, sodass während des Betriebs der Sensorvorrichtung auf beiden Enden der Leiterbahn, welche von der Unterbrechung getrennt werden, das gleiche elektrische Potential anliegt.

Vorzugsweise kann die Unterbrechung so ausgeführt und/oder angeordnet sein, dass ein erster Teil einer Leiterbahn auf einer Ebene (d. h. Lage der Leiterplattenanordnung) und ein zweiter Teil der Leiterbahn auf der gleichen Ebene nur über wenigstens eine Durchkontaktierung (d. h. insbesondere über eine weitere Ebene) miteinander verbunden sind. Der erste Teil und der zweite Teil können z. B. Teile des Abschirmelements und/oder weiteren Abschirmelements und/oder des Kantensensorelements auf einer gemeinsamen Ebene sein. In anderen Worten kann auf einer der Lagen mit dem Abschirmelement bzw. dem Kantensensorelement das jeweilige (Abschirm- oder Kantensensor-) Element verschiedene Teile (insbesondere in der Form von Leiterbahnabschnitten) aufweisen, welche ausschließlich über wenigstens eine Durchkontaktierung und somit nicht direkt auf der Lage miteinander verbunden sind. Damit können Schleifen verhindert und Störungen reduziert werden.

Auch ist es denkbar, dass möglichst viele Durchkontaktierungen zwischen den Ebenen der Leiterplattenanordnung vorgesehen sind, um die Abschirmwirkung zu erhöhen. Dabei können z. B. pro Abschirmelement wenigstens zwei oder wenigstens vier oder wenigstens 10 oder wenigstens 20 redundante Durchkontaktierungen zu einem weiteren Abschirmelement auf einer anderen Ebene vorgesehen sein, um die beiden Abschirmelemente verschiedener Ebenen miteinander elektrisch zu verbinden.

Weiter ist es denkbar, dass ein Abschirmelement auf einer Lage der Leiterplattenanordnung dadurch gebildet ist, dass ein erster Leiterbahnabschnitt des Abschirmelements mit einem zweiten Leiterbahnabschnitt des Abschirmelements (insbesondere ausschließlich) über wenigstens eine Durchkontaktierung elektrisch verbunden ist, und damit insbesondere über eine elektrische Verbindung einer weiteren Lage verbunden ist, um vorzugsweise die Leiterbahnabschnitte des Abschirmelements über diese Verbindung auf ein gleiches Potential zu legen.

In ähnlicher Weise ist es möglich, dass ein Kantensensorelement auf einer Lage der Leiterplattenanordnung dadurch gebildet ist, dass ein erster Leiterbahnabschnitt des Kantensensorelements mit einem zweiten Leiterbahnabschnitt des Kantensensorelements (insbesondere ausschließlich) über wenigstens eine Durchkontaktierung elektrisch verbunden ist, und damit insbesondere über eine elektrische Verbindung einer weiteren Lage verbunden ist, um vorzugsweise die Leiterbahnabschnitte des Kantensensorelements über diese Verbindung auf ein gleiches Potential zu legen.

Es kann weiter möglich sein, dass wenigstens zwei Lagen der Leiterplattenanordnung jeweils eines des wenigstens einen Abschirmelements aufweisen, und vorzugsweise wenigstens zwei (davon unterschiedliche) Lagen der Leiterplattenanordnung jeweils ein weiteres Abschirmelement aufweisen, wobei wenigstens eine Durchkontaktierung vorgesehen ist, um die Abschirmelemente elektrisch miteinander zu verbinden, sodass die verbundenen Abschirmelemente ein gleiches elektrisches Potential aufweisen, wobei vorzugsweise wenigstens eine Unterbrechung als eine Anpassung wenigstens eines der Abschirmelemente vorgesehen ist, um die Ausbildung von Schleifen und/oder Stromkreisen zu verhindern, sodass bevorzugt nur ein Pfad die Abschirmelemente miteinander lagenübergreifend verbindet. Dies ermöglicht eine zuverlässige Verringerung von Störungen durch eine gegenseitige Beeinflussung verschiedener elektrischer Komponenten der Sensorvorrichtung.

Auch ist es optional denkbar, dass wenigstens eine Durchkontaktierung vorgesehen ist, um wenigstens ein Element, insbesondere das wenigstens eine Abschirmelement und/oder wenigstens ein weiteres Abschirmelement und/oder wenigstens ein Antennenelement und/oder das wenigstens eine Kantensensorelement, lagenübergreifend bei der Leiterplattenanordnung miteinander elektrisch zu verbinden und so auf ein gemeinsames Potential zu legen, wobei vorzugsweise wenigstens eine Unterbrechung als eine Anpassung wenigstens eines des wenigstens einen Elements vorgesehen ist, um die Ausbildung von Stromkreisen und/oder Schleifen durch die Verbindung zu verhindern. Dies hat den Vorteil, dass eine einfache Maßnahme zu einer deutlichen Verbesserung der kapazitiven Erfassung und/oder der Kommunikation durch das wenigstens eine Antennenelement führen kann.

Insbesondere wird unter einer Unterbrechung als Anpassung eine Anpassungsart verstanden, bei welcher ein elektrischer Leiter so unterbrochen wird, dass ein Stromfluss durch die Unterbrechung im Normalbetrieb der Sensorvorrichtung verhindert ist. Insbesondere ist ein solcher Stromfluss ein Stromfluss eines Wirbelstromes, welcher durch das wenigstens eine Antennenelement induziert werden kann.

Des Weiteren ist es im Rahmen der Erfindung optional möglich, dass wenigstens drei oder wenigstens fünf oder wenigstens sieben Unterbrechungen als eine Anpassung vorgesehen sind, um bevorzugt Störungen bei wenigstens einem und/oder durch wenigstens ein Antennenelement an der Leiterplattenanordnung zu verringern und/oder um eine Entkopplung des wenigstens einen Kantensensorelements von dem wenigstens einen Antennenelement bereitzustellen. Alternativ oder zusätzlich können die Unterbrechungen auf verschiedenen Lagen der Leiterplattenanordnung vorgesehen sein.

Zudem ist es im Rahmen der Erfindung denkbar, dass das wenigstens eine Kantensensorelement und/oder das wenigstens eine Abschirmelement jeweils derart angepasst an wenigstens ein Antennenelement angeordnet ist, insbesondere im Wesentlichen an einem Mittelpunkt eines Antennenelements in einer Längsrichtung der Leiterplattenanordnung, einen Verbindungsabgriff für eine elektrische Verbindung zu der Verarbeitungsvorrichtung aufweist, um insbesondere einen elektrischen Einfluss durch das Antennenelement zu verringern. Hierbei kann der Vorteil erzielt werden, dass in diesem Mittenbereich sich nur ein sehr geringer Strom und/oder nur eine sehr geringe Spannung bei dem wenigstens einen Antennenelement ausbildet. Entsprechend kann ein Störeinfluss an dieser Stelle für den Verbindungsabgriff reduziert sein.

Ferner kann im Rahmen der Erfindung vorgesehen sein, dass das wenigstens eine Kantensensorelement und/oder das wenigstens eine Abschirmelement über jeweils einen Verbindungsabgriff und/oder über wenigstens einen Entkopplungswiderstand mit der Verarbeitungsvorrichtung elektrisch verbunden ist, wobei vorzugsweise ein Abschnitt zwischen dem Verbindungsabgriff und dem jeweiligen Entkopplungswiderstand der Verbindung einen gestörten Leitungsabschnitt ausbildet, wobei bevorzugt der jeweilige Entkopplungswiderstand maximal 1 cm oder maximal 0,5 cm oder maximal 0,1 cm entfernt vom Verbindungsabgriff angeordnet ist, um den gestörten Leitungsabschnitt der Verbindung zu verringern. In anderen Worten kann der Abstand zwischen dem Verbindungsabgriff und dem Entkoppelungswiderstand möglichst geringgehalten werden, um einen gestörten Leitungsabschnitt klein zu halten.

Vorteilhaft ist es zudem, wenn wenigstens eines des wenigstens einen Abschirmelements und/oder ein weiteres Abschirmelement, vorzugsweise auf einer gleichen Lage wie das wenigstens eine Kantensensorelement, als ein passives Abschirmelement ausgebildet ist. Ein solches passives Abschirmelement kann bspw. dazu ausgeführt sein, zur Abschirmung stets ein gleichbleibendes elektrisches Potential aufzuweisen. Es kann sich dabei um ein Massepotential oder um ein von einem Massepotential unterschiedliches Potential handeln. Dabei kann das elektrische Potential während eines Betriebs der Sensorvorrichtung unveränderbar sein.

Es kann optional möglich sein, dass wenigstens ein aktives Abschirmelement an der Leiterplattenanordnung vorgesehen ist, vorzugsweise auf einer Lage der Leiterplattenanordnung, welche unmittelbar benachbart zu einer Lage mit einem Sensorelement zur kapazitiven Erfassung ausgebildet ist, um insbesondere eine Abschirmung von einem ungewünschten Bereich und/oder Umgebungsbereich der Leiterplattenanordnung für die Detektion und/oder für das Sensorelement bereitzustellen. Ein solches aktives Abschirmelement kann bspw. dazu ausgeführt sein, während eines Betriebs der Sensorvorrichtung das elektrische Potential zu verändern. Bspw. kann das elektrische Potential des aktiven Abschirmelements im Gegensatz zum passiven Abschirmelement veränderbar und/oder an das Sensorelement angepasst sein. Vorzugsweise kann das Potential des aktiven Abschirmelements mit dem Potential des Sensorelements mitgeführt werden und/oder diesem Potential des Sensorelements angeglichen werden und/oder dem Potential des Sensorelements entsprechen.

Nach einer weiteren Möglichkeit kann vorgesehen sein, dass das wenigstens eine Abschirmelement und/oder wenigstens ein weiteres aktives Abschirmelement zur Abschirmung von wenigstens einem ungewünschten Bereich für wenigstens eine kapazitive Erfassung, insbesondere des wenigstens einen Kantensensorelements und/oder Sensorelements, ausgeführt ist. Dies kann den Betrieb einer erfindungsgemäßen Sensorvorrichtung verbessern.

Es ist ferner möglich, dass wenigstens eines des wenigstens einen Kantensensorelements jeweils mehr als eine Durchkontaktierung, z. B. wenigstens zwei oder wenigstens vier oder wenigstens 10 oder wenigstens 20 redundante Durchkontaktierungen zu einem weiteren Kantensensorelement einer anderen Ebene der Leiterplattenanordnung, aufweist. Auf diese Weise kann die Kantenerkennung verbessert werden.

Ebenfalls Gegenstand der Erfindung ist ein Türgriff für ein Fahrzeug mit einer erfindungsgemäßen Sensorvorrichtung. Damit bringt der erfindungsgemäße Türgriff die gleichen Vorteile mit sich, wie sie ausführlich mit Bezug auf eine erfindungsgemäße Sensorvorrichtung beschrieben worden sind. Dabei kann es vorgesehen sein, dass eine erfindungsgemäße Sensorvorrichtung derart in einen erfindungsgemäßen Türgriff montiert wird, dass sich ein erster Randbereich der Sensorvorrichtung entlang und/oder benachbart zu einer oberen Kante des Türgriffs und ein zweiter Randbereich der Sensorvorrichtung entlang und/oder benachbart zu einer unteren Kante des Türgriffs erstreckt. Insbesondere kann dabei die Montage derart erfolgen, dass ein erstes Kantensensorelement einer erfindungsgemäßen Sensorvorrichtung zur Überwachung und/oder Detektion im Bereich einer oberen Kante des Türgriffs erfolgt, und ein zweites Kantensensorelement zur Überwachung und/oder Detektion im Bereich einer unteren Kante des Türgriffs ausgeführt ist. Auf diese Weise kann das wenigstens eine Kantensensorelement dazu ausgeführt sein, ein Eingreifen in eine Türmulde des Türgriffs zu detektieren und/oder kapazitiv zu erfassen.

Es ist möglich, dass im montierten Zustand der Sensorvorrichtung eine obere Kante des Türgriffs in einem ersten Randbereich der Leiterplattenanordnung und eine untere Kante des Türgriffs in einem zweiten Randbereich der Leiterplattenanordnung liegt. Damit kann ein erstes Kantensensorelement im ersten Randbereich zur Überwachung der oberen Kante und ein zweites Kantensensorelement im zweiten Randbereich zur Überwachung der unteren Kante dienen.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: Eine schematische Seitenansicht eines Fahrzeuges mit einer erfindungsgemäßen Sensorvorrichtung und mit einem erfindungsgemäßen Türgriff,
- Fig. 2 und 3: schematische Ansichten verschiedener Lagen einer Leiterplattenanordnung einer erfindungsgemäßen Sensorvorrichtung in einer Draufsicht,
- Fig. 4 und 5: schematische Schaltbilder einer erfindungsgemäßen Sensorvorrichtung,
- Fig. 6+7: eine schematische Darstellung einer Leiterbahn einer erfindungsgemäßen Sensorvorrichtung.

In den nachfolgenden Figuren werden für die gleichen technischen Merkmale auch von unterschiedlichen Ausführungsbeispielen die identischen Bezugszeichen verwendet.

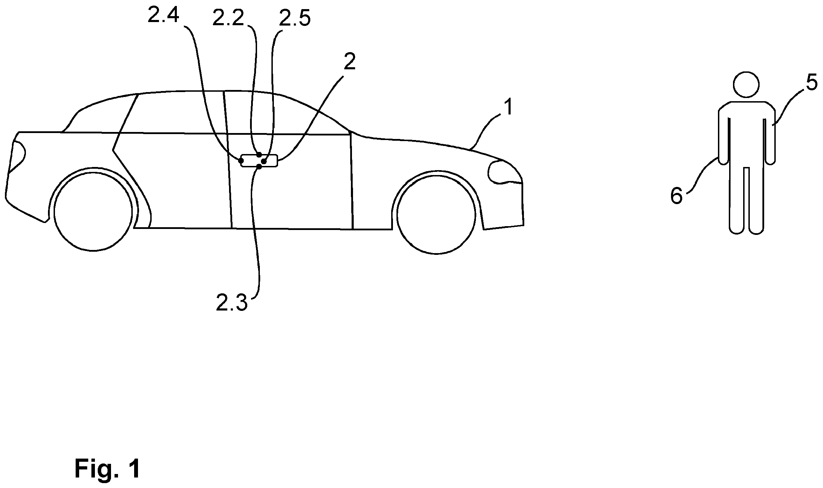

Figur 1 zeigt schematisch eine Seitenansicht eines Fahrzeuges 1, welches einen erfindungsgemäßen Türgriff 2 aufweist. Es können auch ggf. weitere erfindungsgemäße Türgriffe 2 vorgesehen sein, z. B. an weiteren oder sämtlichen Seitentüren und/oder an einer Heckklappe oder Frontklappe des Fahrzeuges 1. Alternativ oder zusätzlich kann auch eine erfindungsgemäße Sensorvorrichtung 10 am Fahrzeug 1 außerhalb des Türgriffs oder der Türgriffe 2 vorgesehen sein. Das Fahrzeug 1 weist z. B. ein passives Zugangssystem auf, sodass bei einer Detektion einer Annäherung eines Bedieners 5 eine Authentifizierung automatisch initiiert wird. Hierzu kann z. B. die Annäherung des Bedienmittels 6, wie einer Hand des Bedieners 5, als Aktivierungshandlung erfasst werden. Bspw. führt das Eingreifen in eine Türgriffmulde zur Initiierung der Authentifizierung und/oder zur Entriegelung. Auch können andere Annäherungen und/oder Gesten als Aktivierungshandlung vorgesehen sein, um die Authentifizierung und/oder eine weitere Funktion wie die Ent- oder Verriegelung zu initiieren. Beispielhaft wird nachfolgend die Aktivierungshandlung am Türgriff 2 näher betrachtet, für welche als potentielle Bereiche zur Ausführung der Aktivierungshandlung eine untere Kante 2.3 und/oder eine obere Kante 2.2 und/oder ein Seitenbereich 2.4 und/oder ein Mittenbereich 2.5 des Türgriffs 2 sein können. Hierzu kann eine erfindungsgemäße Sensorvorrichtung 10 eine kapazitive Erfassung in wenigstens einem dieser Bereiche durchführen.

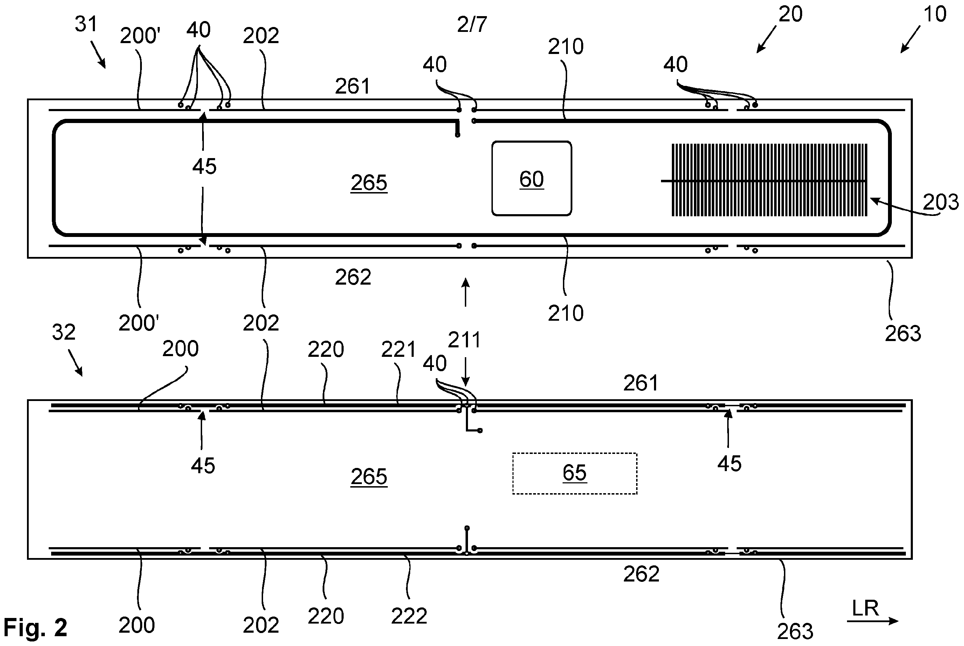

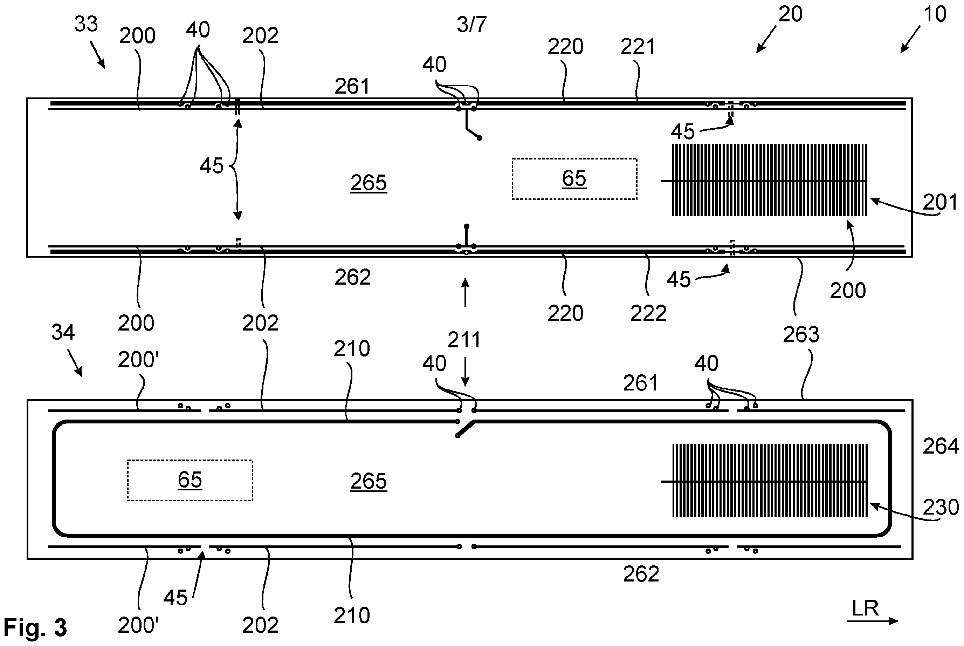

In Figur 2 und 3 gezeigt sind Draufsichten auf verschiedene Lagen 31, 32, 33, 34 einer Leiterplattenanordnung 20 einer erfindungsgemäßen Sensorvorrichtung 10 zur Detektion einer Aktivierungshandlung bei einem Fahrzeug 1. Die Sensorvorrichtung 10 dient dabei zur Montage in eine Fahrzeugkomponente - wie einen Türgriff 2 - des Fahrzeuges 1. Im in den Türgriff montierten Zustand der Sensorvorrichtung 10 entspricht die mit einem Pfeil dargestellte Längsrichtung LR einer Richtung parallel zur Fahrzeuglängsachse. Ein erster Randbereich 261 der Lagen ist in diesem montierten Zustand näher an einer oberen Kante 2.2 des Türgriffs 2 als ein zweiter Randbereich 262. Anders ausgedrückt kann im montierten Zustand der Sensorvorrichtung 10 die obere Kante 2.2 im ersten Randbereich 261 und die untere Kante 2.3 des Türgriffs 2 im zweiten Randbereich 262 liegen. Damit kann zuverlässig ein Eingreifen in eine Türgriffmulde des Türgriffs 2 durch Kantensensorelemente 220 in den Randbereichen 261, 262 kapazitiv erfasst werden. Optional kann auch nur einer der Kantensensorelemente 220 genutzt werden, und das andere Kantensensorelement deaktiviert werden oder nicht vorgesehen sein.

Gemäß einem Ausführungsbeispiel weist eine erfindungsgemäße Sensorvorrichtung 10 eine Leiterplattenanordnung 20 mit mehreren Lagen (also Leiterplattenebenen) 31, 32, 33, 34 auf. Weiter weist die Sensorvorrichtung 10 auf dieser Leiterplattenanordnung 20 wenigstens eine Verarbeitungsvorrichtung 60 auf, welche in einem Mittenbereich 265 der Leiterplattenanordnung 20 auf wenigstens einer der Lagen 31, 32, 33, 34 angeordnet ist. Konkret gezeigt ist in Figur 2 die Verarbeitungsvorrichtung 60 auf einer ersten Leiterbahnebene 31 (erste Lage 31), wobei im Mittenbereich 265 auf jeder der Lagen auch weitere Elektronik 65 vorgesehen sein kann. Diese weitere Elektronik 65 kann z. B. Leiterbahnen aufweisen, welche die Verarbeitungsvorrichtung 60 mit weiteren Elementen verbinden, und/oder wenigstens einen Kondensator zur kapazitiven Erfassung (wie zur Ladungsübertragung von den Sensorelementen oder Kantensensorelementen) aufweisen. Es ist ferner wenigstens ein Kantensensorelement 220 vorgesehen, welches in einem zum Mittenbereich 265 angrenzenden Randbereich 261, 262 der Leiterplattenanordnung 20 zur kapazitiven Erfassung angeordnet ist. Die kapazitive Erfassung kann genutzt werden, um zumindest teilweise die Detektion bereitzustellen, also eine Umgebung der Sensorvorrichtung 10 zu überwachen. Um diese Erfassung zu verbessern, ist zudem (dem jeweiligen Kantensensorelement 220 zugeordnet) wenigstens ein Abschirmelement 200 an der Leiterplattenanordnung 20 angeordnet, welches sich zwischen dem wenigstens einen Kantensensorelement 220 und dem Mittenbereich 265 erstreckt.

In Figur 2 und 3 ist gezeigt, dass eine zweite Leiterbahnebene 32 (d. h. zweite Lage 32) und eine dritte Leiterbahnebene 33 (d. h. dritte Lage 33) jeweils das Kantensensorelement 220 aufweist, und zwar jeweils ein erstes (oberes) Kantensensorelement 221 in einem ersten Randbereich 261 und jeweils ein zweites (unteres) Kantensensorelement 222 in einem zweiten Randbereich 262. Entsprechend kann das erste Kantensensorelement 221 zur kapazitiven Erfassung im ersten Randbereich 261 und ggf. an einer oberen Kante 2.2 des Türgriffs 2, und das zweite Kantensensorelement 222 zur kapazitiven Erfassung im zweiten Randbereich 262 und ggf. an einer unteren Kante 2.2 des Türgriffs 2 ausgeführt sein. Für jedes dieser Kantensensorelemente 221, 222 kann benachbart ein Abschirmelement 200 vorgesehen sein, welches den Mittenbereich 265 vom Kantensensorelement 220 trennt. Es kann sich dabei um ein passives Abschirmelement 200 handeln, welches sich somit im Betriebszustand der Sensorvorrichtung 10 stets auf einem festen elektrischen Potential (Masse oder davon abweichend) befindet. Dabei kann das wenigstens eine Kantensensorelement 220 und ggf. auch das wenigstens eine Abschirmelement 200 jeweils als langestreckte Elektrode ausgebildet sein, insbesondere in der Form einer Leiterbahn der Leiterplattenanordnung 20. Das wenigstens eine Kantensensorelement 220 kann bspw. durch die Verarbeitungsvorrichtung 60 zur kapazitiven Erfassung wiederholt aufgeladen werden, und damit (anders als das wenigstens eine Abschirmelement 200) ein wechselndes elektrisches Potential aufweisen.

Die Leiterplattenanordnung 20 ist im gezeigten Beispiel als eine mehrlagige Leiterplatte 20 ausgebildet, sodass die Leiterplattenanordnung 20 wenigstens zwei oder wenigstens oder genau vier Lagen 31, 32, 33, 34 aufweist, wobei zumindest zwei 32, 33 der Lagen 31, 32, 33, 34 jeweils wenigstens eines des wenigstens einen Kantensensorelements 220 aufweisen, welche zumindest teilweise über Durchkontaktierungen 40 miteinander elektrisch verbunden sind. Dies ermöglicht es, dass ein lagenübergreifendes elektrisches Leiterelement für ein jeweiliges Kantensensorelement 220 in jedem Randbereich 261, 262 bereitgestellt wird. In anderen Worten können das wenigstens eine Kantensensorelement 220 mehrere Kantensensorelemente 220 umfassen, wobei die Kantensensorelemente 220 an gegenüberliegenden Randbereichen 261, 262 der Leiterplattenanordnung 20 elektrisch voneinander entkoppelt sind, und an gleichen Randbereichen 261, 262 elektrisch miteinander verbunden sind, insbesondere auch lagenübergreifend über Durchkontaktierungen 40. In gleicher Weise können ggf. auch die Abschirmelemente 200 eines gleichen Randbereichs 261, 262 miteinander lagenübergreifend über Durchkontaktierungen 40 elektrisch verbunden sein. Für jedes des wenigstens einen Kantensensorelements 220 ist im gezeigten Beispiel auf den Lagen 32 und 33 ein zugehöriges Abschirmelement 200 vorgesehen, welches sich zumindest teilweise oder überwiegend parallel zum jeweiligen Kantensensorelement 220 erstreckt.

Außerdem gezeigt ist auf der vierten Lage 34 ein zusätzliches Sensorelement 230 zur kapazitiven Erfassung zumindest teilweise außerhalb eines Randbereichs 261, 262 der Leiterplattenanordnung 20 und/oder angrenzend zu einem Seitenbereich 264 der Sensorvorrichtung 10. Dieses ist an der Leiterplattenanordnung 20 an der Lage 34 der Leiterplattenanordnung 20 angeordnet, welche sich von einer Lage 32, 33 mit dem wenigstens einen Kantensensorelement 220 unterschiedet, um auf diese Weise im montierten Zustand die Detektion zumindest teilweise in einem Seitenbereich 2.4 und/oder Mittenbereich 2.5 des Türgriffs 2 (wie die Detektion eines Auflegens des Bedienmittels 6 wie der Hand auf den Türgriff 2 außerhalb der Türgriffmulde) bereitzustellen. Hierzu kann das Sensorelement 230 wie die Kantensensorelemente 220 zur kapazitiven Auswertung mit der oder einer weiteren Verarbeitungsvorrichtung 60 elektrisch verschaltet sein.

Darüber hinaus ist in Figur 2 und 3 ein Antennenelement 210, vorzugsweise eine NFC-Antenne, zumindest teilweise oder überwiegend in einem Randbereich 261, 262 der Leiterplattenanordnung 20 zur Bereitstellung einer kontaktlosen Kommunikation angeordnet. Das Antennenelement 210 ist an genau zwei Lagen 31, 34 der Leiterplattenanordnung 20 ausgebildet, und erstreckt sich entlang gegenüberliegender Randbereiche 261, 262 der Lagen 31, 34. Um lagenübergreifend ausgebildet sein zu können, ist das Antennenelement 210 durch wenigstens eine Durchkontaktierung 40 auf den verschiedenen Lagen 31, 34 verbunden. Wie bei den Kantensensorelementen 220 ist auch bei dem Antennenelement 210 ein weiteres Abschirmelement 200' vorgesehen, welches sich zumindest teilweise zwischen dem Antennenelement 210 und einem Rand 263 der Leiterplattenanordnung 20 erstreckt, um das Antennenelement 210 von einer Umgebung der Leiterplattenanordnung 20 im Randbereich 261, 262 abzuschirmen und/oder umgekehrt. Auch das weitere Abschirmelement 200' kann als passives Abschirmelement 200' ausgebildet sein. Anders als bei dem Abschirmelement 200 für das Kantensensorelement 220, welches als inneres Abschirmelement 200 ausgebildet ist, kann es sich bei dem weiteren Abschirmelement 200' um ein äußeres Abschirmelement 200' handeln.

Außerdem kann auch für das weitere Sensorelement 230 ein Abschirmelement 201 vorgesehen sein, welches als aktives Abschirmelement 201 ausgeführt ist. Dieses kann ein veränderbares elektrisches Potential haben, welches z. B. in Abhängigkeit von dem Potential des Sensorelements 230 festgelegt wird. Anders als das Abschirmelement 200, 200' kann das Abschirmelement 201 auf einer Lage 33 angeordnet sein, welche sich von der Lage 34 mit dem Sensorelement 230 unterscheidet. Es kann dennoch hinsichtlich der Position in Längsrichtung LR und in Höhenrichtung mit dem Sensorelement 230 zumindest teilweise überlappen. Ferner kann ein Masseelement 203 ebenfalls auf einer anderen Lage 31 für das Abschirmelement 201 vorgesehen sein, ggf. ebenfalls in gleicher oder überlappender Position in Längs- und Höhenrichtung. Dagegen können die Kantensensorelemente 220 und die zugehörigen Abschirmelemente 200 nur in Querposition und/oder Längsrichtung LR teilweise überlappen, aber in Höhenrichtung versetzt voneinander sein (vgl. Figur 2 und 3).

In den Figuren 2, 3 sind die Durchkontaktierung 40 (Vias 40) nur vereinzelt mit Bezugszeichen versehen.

Es kann zur Verbesserung der Detektion und/oder einer Kommunikation mittels des Antennenelement 210 wenigstens eine Anpassung 45, 46, 47 vorgesehen sein. Beispielhaft sind in den Figuren 2 und 3 als Anpassung mehrere Unterbrechungen 45 der Abschirmelemente 200, 200' und der Kantensensorelemente 220 gezeigt, welche eine elektrische Unterbrechung der Leiterbahn des jeweiligen Elements 200, 200', 220 bewirken. Auf diese Weise kann ein elektrischer Einfluss und/oder eine elektrische Störung des jeweils dazu benachbarten Antennenelements 210 bei der Leiterplattenanordnung 20 verringert werden.

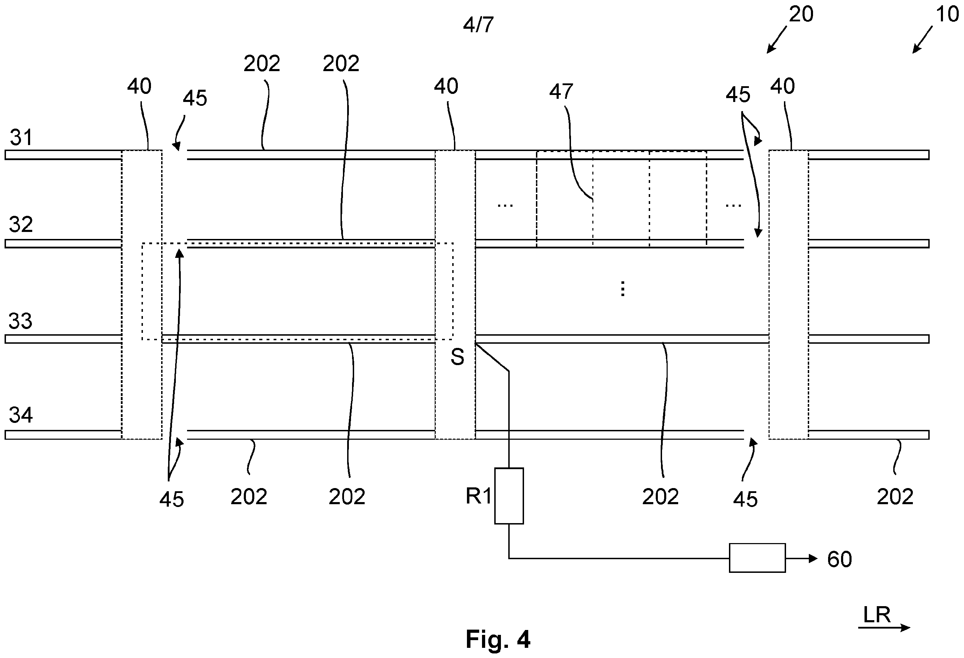

Während die Figuren 2 und 3 die Erstreckung der Lagen 31 bis 34 zweidimensional jeweils in Höhen- und Längsrichtung zeigen, ist in Figur 4 der Aufbau der Lagen 31 bis 34 zweidimensional in Quer- und Längsrichtung gezeigt. Die unterste Lage 34 kann dabei am entferntesten von einer Türgriffmulde und die oberste Lage 31 der Türgriffmulde am nächsten sein. Es ist eine Schnittansicht durch die Durchkontaktierungen 40 gezeigt, um die Verwendung von Unterbrechungen 45 als Anpassung zu verdeutlichen. So kann diese Anpassung 45 bei lagenübergreifenden elektrischen Verbindungen der Leiterplattenanordnung 20 vorgesehen sein, um Störungen bei wenigstens einem Antennenelement 210 an der Leiterplattenanordnung 20 zu verringern. Es sind in Figur 4 die Unterbrechungen 45 des jeweils in den Figuren 2 und 3 dargestellten Abschirmelements 202 beispielhaft gezeigt, wobei eine entsprechende Anordnung auch für das Kantensensorelement 220 vorgesehen sein kann. Es wird deutlich, dass durch die Anpassung 45 ein Stromkreis und/oder eine Schleife S für einen durch wenigstens ein Antennenelement 210 der Leiterplattenanordnung 20 induzierten Strom, vorzugsweise Wirbelstrom, unterbrochen werden kann. In anderen Worten kann eine Unterbrechung 45 als eine Anpassung 45 im Bereich wenigstens einer Durchkontaktierung 40 vorgesehen sein, welche das Abschirmelement 200 einer Lage 32, 33 der Leiterplattenanordnung 20 mit dem wenigstens einen Abschirmelement 200 und/oder weiteren Abschirmelementen 200' wenigstens einer weiteren Lage 31, 32, 33, 34 der Leiterplattenanordnung 20 elektrisch verbindet, um eine Schleife S dieser Verbindung zu unterbrechen. Es ist dabei erkennbar, dass auf den Lagen 31, 32 und 34 das Abschirmelement 202 verschiedene Leiterbahnabschnitte aufweist, welche ausschließlich über wenigstens eine Durchkontaktierung 40 und somit nicht direkt auf einer der Lagen miteinander verbunden sind. Damit können Schleifen verhindert und Störungen reduziert werden.

Als Alternative hierzu kann auch als Anpassung eine Gitter-Struktur 47 vorgesehen sein. Diese ist beispielhaft mit einer gestrichelten Linie dargestellt, bei welcher durch Durchkontaktierungen 40 sehr viele kleinere Schleifen 47 gebildet werden. Auf diese Weise kann die Entkopplung zum Antennenelement 210 verbessert werden. Die in Figur 4 dargestellte Gitter-Struktur 47 kann bei dem Abschirmelement 202 - alternativ oder zusätzlich in der Form aber auch bei dem Kantensensorelement 220 vorgesehen sein.

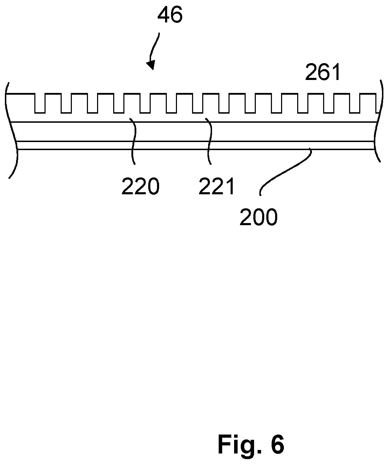

Gemäß einer in Figur 6 gezeigten Variante können alternativ oder zusätzlich Schlitze 46 lagenübergreifender elektrischer Verbindungen der Leiterplattenanordnung 20, insbesondere des wenigstens einen Kantensensorelements 220, als eine Anpassung vorgesehen sein, sodass die Schlitze 46 als mehrere insbesondere randseitige Ausnehmungen der Verbindungen ausgebildet sind, um Störungen bei wenigstens einem und/oder durch wenigstens ein Antennenelement 210 an der Leiterplattenanordnung 20 zu verringern und/oder um eine Entkopplung des wenigstens einen Kantensensorelements 220 von dem wenigstens einen Antennenelement 210 bereitzustellen. Im gezeigten Beispiel sind wiederholt in Längsrichtung LR Aussparungen bei der elektrischen Leiterbahn für das Kantensensorelement 220 vorgesehen. Diese sind in Richtung des Randbereichs 261 (insbesondere in Richtung einer Kante) der Leiterplattenanordnung 20 (also kantenseitig) angeordnet und ausgerichtet. Eine entsprechende Ausbildung kann ggf. auch bei einem Abschirmelement 200 vorgesehen sein.

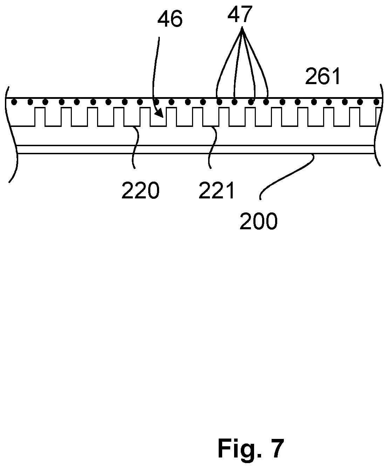

Es ist als eine weitere Variante möglich, dass wie in Figur 7 gezeigt (insbesondere als eine zweite Art der Anpassung) Schlitze 46 des wenigstens einen Kantensensorelements 220 vorgesehen sein, welche wie in Figur 6 als beabstandet angeordnete wiederholte Ausnehmungen des Kantensensorelements 220 ausgeführt sind. Diese können auch als kammartig und/oder jeweils rechteckig ausgebildet beschrieben werden. Dabei können die Schlitze 46 gemäß dieser Variante in umgekehrter Richtung als in Figur 6 weg vom Randbereich 261 (insbesondere weg von einer Kante) der Leiterplattenanordnung 20 (also kantenabgewandt) angeordnet und ausgerichtet sein, d. h. in anderen Worten in Richtung des Mittenbereichs 265 der Leiterplattenanordnung 20 angeordnet und ausgerichtet sein. Zusätzlich können mehrere redundante Durchkontaktierungen 47 des wenigstens einen Kantensensorelements 220 vorgesehen sein, um die Kantensensorelemente 220 auf unterschiedlichen Ebenen der Leiterplattenanordnung 20 miteinander elektrisch zu verbinden. Auf diese Weise kann eine Gitter-Struktur 47 (insbesondere als eine erste Art der Anpassung) bereitgestellt werden. In Figur 7 sind daher den Durchkontaktierungen 47 das Bezugszeichen 47 zugeordnet, welche die Gitterstruktur 47 mit einer Anordnung vergleichbar zu Figur 4 bereitstellen.

Figur 2 bis 4 zeigen, dass wenigstens zwei Lagen 32, 33 der Leiterplattenanordnung 20 jeweils eines des wenigstens einen Abschirmelements 200 aufweisen, und vorzugsweise wenigstens zwei Lagen 31, 34 der Leiterplattenanordnung 20 jeweils ein weiteres Abschirmelement 200' aufweisen, wobei wenigstens eine Durchkontaktierung 40 vorgesehen ist, um die Abschirmelemente 200, 200' elektrisch miteinander zu verbinden, sodass die verbundenen Abschirmelemente 200, 200' ein gleiches elektrisches Potential aufweisen, wobei wenigstens eine Unterbrechung 45 als eine Anpassung 45 wenigstens eines der Abschirmelemente 200, 200' vorgesehen ist, um die Ausbildung von Schleifen S und/oder Stromkreisen zu verhindern, sodass bevorzugt nur ein Pfad die Abschirmelemente 200, 200' miteinander lagenübergreifend verbindet.

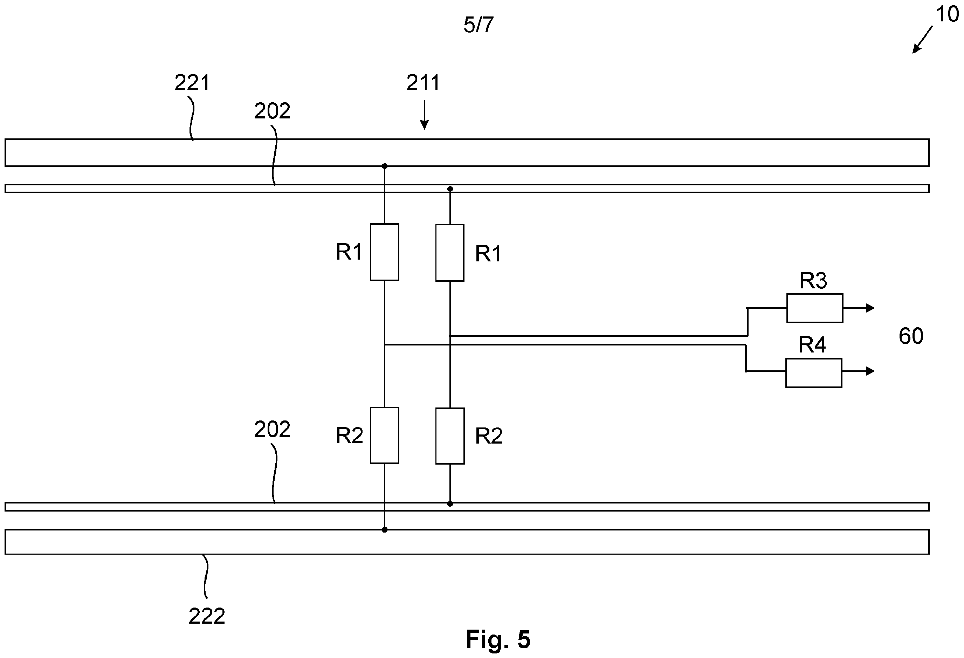

In Figur 5 ist gezeigt, dass das wenigstens eine Kantensensorelement 220 und/oder das wenigstens eine Abschirmelement 200 jeweils derart angepasst an wenigstens einem Antennenelement 210 angeordnet sind, insbesondere im Wesentlichen an einem Mittelpunkt 211 eines Antennenelements 210 in einer Längsrichtung LR der Leiterplattenanordnung 20, einen Verbindungsabgriff 240 für eine elektrische Verbindung zu der Verarbeitungsvorrichtung 60 aufweist, um einen elektrischen Einfluss durch das Antennenelement 210 zu verringern. Ferner kann gemäß Figur 5 das wenigstens eine Kantensensorelement 220 und/oder das wenigstens eine Abschirmelement 200 über jeweils einen Verbindungsabgriff 240 und über wenigstens einen Entkopplungswiderstand R1, R2 mit der Verarbeitungsvorrichtung 60 elektrisch verbunden sein, wobei ein Abschnitt zwischen dem Verbindungsabgriff 240 und dem jeweiligen Entkopplungswiderstand R1, R2 der Verbindung einen gestörten Leitungsabschnitt ausbildet, wobei der jeweilige Entkopplungswiderstand R1, R2 maximal 1 cm oder maximal 0,5 cm oder maximal 0,1 cm entfernt vom Verbindungsabgriff 240 angeordnet ist, um den gestörten Leitungsabschnitt der Verbindung zu verringern. Dabei können bspw. die Widerstände R1, R2, R3, R4 als Spannungsteiler eingesetzt werden, um eine Auswertung und/oder Ladungsübertragung vom Kantensensorelement 220 durchzuführen und/oder ein Potential auf das Abschirmelement 200 zu legen.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: Fahrzeug
- 2: Türgriff
- 2.2: obere Kante
- 2.3: untere Kante
- 2.4: Seitenbereich
- 2.5: Mittenbereich des Türgriffs
- 5: Bediener
- 6: Bedienmittel

- 10: Sensorvorrichtung

- 20: Leiterplattenanordnung, Leiterplatte, mehrlagige Leiterplatte

- 31: erste Leiterbahnebene, erste Lage
- 32: zweite Leiterbahnebene, zweite Lage
- 33: dritte Leiterbahnebene, dritte Lage
- 34: vierte Leiterbahnebene, vierte Lage

- 40: Durchkontaktierung, Via
- 45: Unterbrechung
- 46: Schlitze
- 47: Gitter-Struktur

- 60: Verarbeitungsvorrichtung, Mikrocontroller, Teil der Elektronik
- 65: Elektronik

- 200: Abschirmelement, Shield, inneres Abschirmelement
- 201: Abschirmelement, Aktives Abschirmelement
- 202: Abschirmelement, Passives Abschirmelement
- 203: Masseelement für 201
- 210: Antennenelement, NFC-Antenne
- 211: Mittelpunkt Antennenelement in Längsrichtung

- 220: Kantensensorelement
- 221: oberes Kantensensorelement, erstes Kantensensorelement
- 222: unteres Kantensensorelement, zweites Kantensensorelement
- 230: Sensorelement

- 240: Verbindungsabgriff

- 261: erster Randbereich
- 262: zweiter Randbereich
- 263: Rand
- 264: Seitenbereich
- 265: Mittenbereich

- 200': weiteres Abschirmelement, äußeres Abschirmelement
- LR: Längsrichtung
- Rx: Widerstandselement
- S: Schleife

## Patentansprüche

1. Sensorvorrichtung (10) zur Detektion einer Aktivierungshandlung bei einem Fahrzeug (1), insbesondere für einen Türgriff (2) des Fahrzeuges (1), aufweisend:
- eine Leiterplattenanordnung (20),
- wenigstens eine Verarbeitungsvorrichtung (60), welche in einem Mittenbereich (265) der Leiterplattenanordnung (20) angeordnet ist,
- wenigstens ein Kantensensorelement (220), welches in einem zum Mittenbereich (265) angrenzenden Randbereich (261, 262) der Leiterplattenanordnung (20) zur kapazitiven Erfassung angeordnet ist, um zumindest teilweise die Detektion bereitzustellen,
- wenigstens ein Abschirmelement (200), welches sich zwischen dem wenigstens einen Kantensensorelement (220) und dem Mittenbereich (265) erstreckt, **dadurch gekennzeichnet,**
**dass** wenigstens ein Antennenelement (210) zumindest teilweise oder überwiegend in einem Randbereich (261, 262) der Leiterplattenanordnung (20) zur Bereitstellung einer kontaktlosen Kommunikation angeordnet ist.

2. Sensorvorrichtung (10) nach Anspruch 1,
**dadurch gekennzeichnet,**
**dass** das wenigstens eine Kantensensorelement (220) als wenigstens ein erstes Kantensensorelement (221) und wenigstens ein zweites Kantensensorelement (222) ausgeführt ist, wobei das jeweils erste Kantensensorelement (221) in einem ersten Randbereich (261) der Leiterplattenanordnung (20) und das jeweils zweite Kantensensorelement (222) in einem vom ersten Randbereich (261) gegenüberliegenden zweiten Randbereich (262) angeordnet ist, um die Detektion bei gegenüberliegenden Kanten (2.2, 2.3) des Türgriffs (2) bereitzustellen,
und **dass** das wenigstens eine Kantensensorelement (220) jeweils als langestreckte Elektrode ausgebildet ist, insbesondere in der Form einer Leiterbahn der Leiterplattenanordnung (20).

3. Sensorvorrichtung (10) nach einem der vorhergehenden Ansprüche,
**dadurch gekennzeichnet,**
**dass** die Leiterplattenanordnung (20) als eine mehrlagige Leiterplatte (20) ausgebildet ist, sodass die Leiterplattenanordnung (20) wenigstens zwei oder wenigstens oder genau vier oder wenigstens sechs Lagen (31, 32, 33, 34) aufweist, wobei zumindest zwei (32, 33) der Lagen (31, 32, 33, 34) jeweils wenigstens eines des wenigstens einen Kantensensorelements (220) aufweisen, welche zumindest teilweise über Durchkontaktierungen (40) miteinander elektrisch verbunden sind, wobei bevorzugt die zumindest zwei (32, 33) der Lagen (31, 32, 33, 34) jeweils ein erstes Kantensensorelement (221) und ein zweites Kantensensorelement (222) aufweisen.

4. Sensorvorrichtung (10) nach einem der vorhergehenden Ansprüche,
**dadurch gekennzeichnet,**
**dass** das wenigstens eine Abschirmelement (200) sich zwischen dem wenigstens einen Kantensensorelement (220) und einer Elektronik (65) im Mittenbereich (265) an der Leiterplattenanordnung (20) erstreckt, um insbesondere das wenigstens eine Kantensensorelement (220) von der Elektronik (65) abzuschirmen und/oder umgekehrt, wobei vorzugsweise die Elektronik (65) zumindest teilweise auf einer gleichen Lage (32, 33) mit dem Abschirmelement (200) und zumindest teilweise auf einer unterschiedlichen Lage (32, 33) zur Verarbeitungsvorrichtung (60) angeordnet ist,
und/oder dass das wenigstens eine Kantensensorelement (220) mehrere Kantensensorelemente (220) umfasst, wobei die Kantensensorelemente (220) an gegenüberliegenden Randbereichen (261, 262) der Leiterplattenanordnung (20) elektrisch voneinander entkoppelt sind, und an gleichen Randbereichen (261, 262) elektrisch miteinander verbunden sind, insbesondere auch lagenübergreifend über Durchkontaktierungen (40)
und/oder dass für jedes des wenigstens einen Kantensensorelements (220) ein zugehöriges Abschirmelement (200) vorgesehen ist, welches sich zumindest teilweise oder überwiegend parallel zum jeweiligen Kantensensorelement (220) erstreckt.

5. Sensorvorrichtung (10) nach einem der vorhergehenden Ansprüche,
**dadurch gekennzeichnet,**
**dass** wenigstens ein zusätzliches Sensorelement (230) zur kapazitiven Erfassung zumindest teilweise außerhalb eines Randbereichs (261, 262) der Leiterplattenanordnung (20) an der Leiterplattenanordnung (20) angeordnet ist, vorzugsweise an einer Lage (34) der Leiterplattenanordnung (20), welche sich von einer Lage (32, 33) mit dem wenigstens einen Kantensensorelement (220) unterschiedet, um vorzugsweise die Detektion zumindest teilweise in einem Seitenbereich (2.4) und/oder Mittenbereich (2.5) des Türgriffs (2) bereitzustellen.

6. Sensorvorrichtung (10) nach einem der vorhergehenden Ansprüche,
**dadurch gekennzeichnet,**
**dass**
das wenigstens eine Antennenelement (210) als eine NFC-Antenne ausgebildet ist, und/oder dass das wenigstens eine Antennenelement (210) an wenigstens einer oder genau zwei Lagen (31, 32, 33, 34) der Leiterplattenanordnung (20) ausgebildet ist, und sich bevorzugt entlang gegenüberliegender Randbereiche (261, 262) der Lage (31, 32, 33, 34) erstreckt, und besonders bevorzugt durch wenigstens eine Durchkontaktierung (40) verbunden sich über mehrere Lagen (31, 32, 33, 34) erstreckt.

7. Sensorvorrichtung (10) nach einem der vorhergehenden Ansprüche,
**dadurch gekennzeichnet,**
**dass** wenigstens ein weiteres Abschirmelement (200') vorgesehen ist, welches sich zumindest teilweise zwischen dem Antennenelement (210) und einem Rand (263) der Leiterplattenanordnung (20) erstreckt, um insbesondere das Antennenelement (210) von einer Umgebung der Leiterplattenanordnung (20) im Randbereich (261, 262) abzuschirmen und/oder umgekehrt,
und/oder dass eine Anpassung (45, 46, 47), insbesondere des wenigstens einen Abschirmelements (200) und/oder eines weiteren Abschirmelements (200') und/oder des wenigstens einen Kantensensorelements (220), vorgesehen ist, um einen elektrischen Einfluss und/oder eine elektrische Störung wenigstens eines, insbesondere dazu benachbarten, Antennenelements (210) bei der Leiterplattenanordnung (20) zu verringern.

8. Sensorvorrichtung (10) nach einem der vorhergehenden Ansprüche,
**dadurch gekennzeichnet,**
**dass** eine Anpassung (45, 46, 47) lagenübergreifender elektrischer Verbindungen der Leiterplattenanordnung (20) vorgesehen ist, um Störungen bei dem wenigstens einen Antennenelement (210) an der Leiterplattenanordnung (20) zu verringern.

9. Sensorvorrichtung (10) nach einem der vorhergehenden Ansprüche,
**dadurch gekennzeichnet,**
**dass** eine Gitter-Struktur (47) und/oder Schlitze (46) lagenübergreifender elektrischer Verbindungen der Leiterplattenanordnung (20), insbesondere des wenigstens einen Kantensensorelements (220), als eine Anpassung (46, 47) vorgesehen sind, sodass vorzugsweise mehrfach redundante Schleifen (S) der Verbindungen lagenübergreifend vorgesehen sind und/oder die Schlitze (46) als mehrere insbesondere randseitige Ausnehmungen der Verbindungen ausgebildet sind, um bevorzugt Störungen bei wenigstens einem und/oder durch das wenigstens eine Antennenelement (210) an der Leiterplattenanordnung (20) zu verringern und/oder um eine Entkopplung des wenigstens einen Kantensensorelements (220) von dem wenigstens einen Antennenelement (210) bereitzustellen.

10. Sensorvorrichtung (10) nach einem der vorhergehenden Ansprüche,
**dadurch gekennzeichnet,**
**dass** wenigstens eine Unterbrechung (45) des Abschirmelements (200) und/oder eines weiteren Abschirmelements (200') und/oder des wenigstens einen Kantensensorelements (220) als eine Anpassung (45) vorgesehen ist, insbesondere um einen Stromkreis und/oder eine Schleife (S) für einen durch das wenigstens eine Antennenelement (210) der Leiterplattenanordnung (20) induzierten Stroms, vorzugsweise Wirbelstrom, zu unterbrechen
und/oder dass eine Unterbrechung (45) als eine Anpassung (45) im Bereich wenigstens einer Durchkontaktierung (40) vorgesehen ist, welche das Abschirmelement (200) einer Lage (32, 33) der Leiterplattenanordnung (20) mit dem wenigstens einen Abschirmelement (200) und/oder weiteren Abschirmelementen (200') wenigstens einer weiteren Lage (31, 32, 33, 34) der Leiterplattenanordnung (20) elektrisch verbindet, um eine Schleife (S) dieser Verbindung zu unterbrechen
und/oder dass wenigstens zwei Lagen (32, 33) der Leiterplattenanordnung (20) jeweils eines des wenigstens einen Abschirmelements (200) aufweisen, und vorzugsweise wenigstens zwei Lagen (31, 34) der Leiterplattenanordnung (20) jeweils ein weiteres Abschirmelement (200') aufweisen, wobei wenigstens eine Durchkontaktierung (40) vorgesehen ist, um die Abschirmelemente (200, 200') elektrisch miteinander zu verbinden, sodass die verbundenen Abschirmelemente (200, 200') ein gleiches elektrisches Potential aufweisen, wobei wenigstens eine Unterbrechung (45) als eine Anpassung (45) wenigstens eines der Abschirmelemente (200, 200') vorgesehen ist, um die Ausbildung von Schleifen (S) und/oder Stromkreisen zu verhindern, sodass bevorzugt nur ein Pfad die Abschirmelemente (200, 200') miteinander lagenübergreifend verbindet.

11. Sensorvorrichtung (10) nach einem der vorhergehenden Ansprüche,
**dadurch gekennzeichnet,**
**dass** wenigstens eine Durchkontaktierung (40) vorgesehen ist, um wenigstens ein Element, insbesondere das wenigstens eine Abschirmelement (200) und/oder wenigstens ein weiteres Abschirmelement (200') und/oder das wenigstens eine Antennenelement (210) und/oder das wenigstens eine Kantensensorelement (220), lagenübergreifend bei der Leiterplattenanordnung (20) miteinander elektrisch zu verbinden und so auf ein gemeinsames Potential zu legen, wobei wenigstens eine Unterbrechung (45) als eine Anpassung (45) wenigstens eines des wenigstens einen Elements vorgesehen ist, um die Ausbildung von Stromkreisen und/oder Schleifen (S) durch die Verbindung zu verhindern.

12. Sensorvorrichtung (10) nach einem der vorhergehenden Ansprüche,
**dadurch gekennzeichnet,**
**dass** wenigstens drei oder wenigstens fünf oder wenigstens sieben Unterbrechungen (45) als eine Anpassung (45) vorgesehen sind, um bevorzugt Störungen bei wenigstens einem und/oder durch das wenigstens eine Antennenelement (210) an der Leiterplattenanordnung (20) zu verringern und/oder um eine Entkopplung des wenigstens einen Kantensensorelements (220) von dem wenigstens einen Antennenelement (210) bereitzustellen.

13. Sensorvorrichtung (10) nach einem der vorhergehenden Ansprüche,
**dadurch gekennzeichnet,**
**dass** das wenigstens eine Kantensensorelement (220) und/oder das wenigstens eine Abschirmelement (200) jeweils derart angepasst an das wenigstens eine Antennenelement (210) angeordnet ist, insbesondere im Wesentlichen an einem Mittelpunkt (211) eines Antennenelements (210) in einer Längsrichtung (LR) der Leiterplattenanordnung (20), einen Verbindungsabgriff (240) für eine elektrische Verbindung zu der Verarbeitungsvorrichtung (60) aufweist, um einen elektrischen Einfluss durch das Antennenelement (210) zu verringern,
und/oder dass das wenigstens eine Kantensensorelement (220) und/oder das wenigstens eine Abschirmelement (200) über jeweils einen Verbindungsabgriff (240) und über wenigstens einen Entkopplungswiderstand (R1, R2) mit der Verarbeitungsvorrichtung (60) elektrisch verbunden ist, wobei ein Abschnitt zwischen dem Verbindungsabgriff (240) und dem jeweiligen Entkopplungswiderstand (R1, R2) der Verbindung einen gestörten Leitungsabschnitt ausbildet, wobei der jeweilige Entkopplungswiderstand (R1, R2) maximal 1 cm oder maximal 0,5 cm oder maximal 0,1 cm entfernt vom Verbindungsabgriff (240) angeordnet ist, um den gestörten Leitungsabschnitt der Verbindung zu verringern.

14. Sensorvorrichtung (10) nach einem der vorhergehenden Ansprüche,
**dadurch gekennzeichnet,**
**dass** wenigstens eines des wenigstens einen Abschirmelements (200) und/oder ein weiteres Abschirmelement (200'), vorzugsweise auf einer gleichen Lage wie das wenigstens eine Kantensensorelement (220), als ein passives Abschirmelement (202) ausgebildet ist,
und/oder dass wenigstens ein aktives Abschirmelement (201) an der Leiterplattenanordnung (20) vorgesehen ist, vorzugsweise auf einer Lage (33) der Leiterplattenanordnung (20), welche unmittelbar benachbart zu einer Lage (34) mit einem Sensorelement (230) zur kapazitiven Erfassung ausgebildet ist, um insbesondere eine Abschirmung von einem ungewünschten Bereich und/oder Umgebungsbereich der Leiterplattenanordnung (20) für die Detektion bereitzustellen,
und/oder dass das wenigstens eine Abschirmelement (200) und/oder ein weiteres aktives Abschirmelement (201) zur Abschirmung von einem ungewünschten Bereich für wenigstens eine kapazitive Erfassung insbesondere des wenigstens einen Kantensensorelements (220) und/oder Sensorelements (230) ausgeführt ist.

15. Türgriff (2) für ein Fahrzeug (1) mit einer Sensorvorrichtung (10) nach einem der vorhergehenden Ansprüche.

## Claims

1. Sensor device (10) for detecting an activation action in a vehicle (1), in particular for a door handle (2) of the vehicle (1):
- a printed circuit board assembly (20),
- at least one processing device (60) disposed in a center region (265) of the printed circuit board assembly (20),
- at least one edge sensor element (220) disposed in an edge region (261, 262) adjacent to the center region (265) of the printed circuit board assembly (20) for capacitive sensing to at least partially provide the detection,
- at least one shielding element (200) extending between the at least one edge sensor element (220) and the center region (265),
**characterized in that** at least one antenna element (210) is disposed at least partially or predominantly in an edge region (261, 262) of the printed circuit board assembly (20) for providing contactless communication.

2. Sensor device (10) according to claim 1,
**characterized in that**
the at least one edge sensor element (220) is designed as at least one first edge sensor element (221) and at least one second edge sensor element (222), the respective first edge sensor element (221) being arranged in a first edge region (261) of the printed circuit board assembly (20) and the respective second edge sensor element (222) being arranged in a second edge region (262) opposite the first edge region (261), in order to provide the detection at opposite edges (2.2, 2.3) of the door handle (2),
and **in that** the at least one edge sensor element (220) is formed in each case as an elongated electrode, in particular in the form of a conductor track of the printed circuit board assembly (20).

3. Sensor device (10) according to any one of the preceding claims,
**characterized in that**
the printed circuit board assembly (20) is designed as a multilayer printed circuit board (20), so that the printed circuit board assembly (20) has at least two or at least or exactly four or at least six layers (31, 32, 33, 34), at least two (32, 33) of the layers (31, 32, 33, 34) each have at least one of the at least one edge sensor element (220), which are at least partially electrically connected to one another via plated-through holes (40), preferably the at least two (32, 33) of the layers (31, 32, 33, 34) each having a first edge sensor element (221) and a second edge sensor element (222).

4. Sensor device (10) according to any one of the preceding claims,
**characterized in that**
the at least one shielding element (200) extends between the at least one edge sensor element (220) and electronics (65) in the center region (265) on the printed circuit board assembly (20), in particular to shield the at least one edge sensor element (220) from the electronics (65) and/or vice versa, preferably the electronics (65) being arranged at least partially on a same layer (32, 33) with the shielding element (200) and at least partially on a different layer (32, 33) to the processing device (60),
and/or **in that** the at least one edge sensor element (220) comprises a plurality of edge sensor elements (220), the edge sensor elements (220) being electrically decoupled from one another at opposite edge regions (261, 262) of the printed circuit board assembly (20), and being electrically connected to one another at the same edge regions (261, 262), in particular also across layers via plated-through holes (40) and/or **in that** for each of the at least one edge sensor element (220) an associated shielding element (200) is provided which extends at least partially or predominantly parallel to the respective edge sensor element (220).

5. Sensor device (10) according to any one of the preceding claims,
**characterized in that**
at least one additional sensor element (230) for capacitive detection is arranged at least partially outside an edge region (261, 262) of the printed circuit board assembly (20) on the printed circuit board assembly (20), preferably on a layer (34) of the printed circuit board assembly (20) which is different from a layer (32, 33) with the at least one edge sensor element (220), preferably in order to provide the detection at least partially in a side region (2.4) and/or center region (2.5) of the door handle (2).

6. Sensor device (10) according to any one of the preceding claims,
**characterized in that**
the at least one antenna element (210) is formed as an NFC antenna, and/or **in that** the at least one antenna element (210) is formed on at least one or exactly two layers (31, 32, 33, 34) of the printed circuit board assembly (20), and preferably extends along opposite edge regions (261, 262) of the layer (31, 32, 33, 34), and particularly preferably extends over a plurality of layers (31, 32, 33, 34) connected by at least one plated-through hole (40).

7. Sensor device (10) according to any one of the preceding claims,
**characterized in that**
at least one further shielding element (200') is provided, which extends at least partially between the antenna element (210) and an edge (263) of the printed circuit board assembly (20), in particular in order to shield the antenna element (210) from an environment of the printed circuit board assembly (20) in the edge region (261, 262) and/or vice versa,
and/or **in that** an adaptation (45, 46, 47), in particular of the at least one shielding element (200) and/or of a further shielding element (200') and/or of the at least one edge sensor element (220), is provided in order to reduce an electrical influence and/or an electrical interference of at least one antenna element (210), in particular adjacent thereto, in the printed circuit board assembly (20).

8. Sensor device (10) according to any one of the preceding claims,
**characterized in that**
an adaptation (45, 46, 47) of cross-fayer electrical connections of the printed circuit board assembly (20) is provided to reduce interference with the at least one antenna element (210) on the printed circuit board assembly (20).

9. Sensor device (10) according to any one of the preceding claims,
**characterized in that**
a grid structure (47) and/or slots (46) of cross-layer electrical connections of the printed circuit board assembly (20), in particular of the at least one edge sensor element (220), are provided as an adaptation (46, 47), so that preferably multiple redundant loops (S) of the connections are provided across layers and/or the slots (46) are formed as a plurality of, in particular, edge-side recesses of the connections, in order to preferably reduce disturbances at at least one and/or by the at least one antenna element (210) at the printed circuit board assembly (20) and/or in order to provide a decoupling of the at least one edge sensor element (220) from the at least one antenna element (210).

10. Sensor device (10) according to any one of the preceding claims,
**characterized in that**
at least one interruption (45) of the shielding element (200) and/or of a further shielding element (200') and/or of the at least one edge sensor element (220) is provided as an adaptation (45), in particular in order to interrupt a circuit and/or a loop (S) for a current, preferably eddy current, induced by the at least one antenna element (210) of the printed circuit board assembly (20)
and/or **in that** an interruption (45) is provided as an adaptation (45) in the region of at least one plated-through hole (40) which electrically connects the shielding element (200) of one layer (32, 33) of the printed circuit board assembly (20) to the at least one shielding element (200) and/or further shielding elements (200') of at least one further layer (31, 32, 33, 34) of the printed circuit board assembly (20) in order to interrupt a loop (S) of this connection
and/or **in that** at least two layers (32, 33) of the printed circuit board assembly (20) each have one of the at least one shielding element (200), and preferably at least two layers (31, 34) of the printed circuit board assembly (20) each have a further shielding element (200'), at least one through-plated hole (40) being provided in order to connect the shielding elements (200, 200') electrically to one another so that the connected shielding elements (200, 200') have the same electrical potential, at least one interruption (45) being provided as an adaptation (45) of at least one of the shielding elements (200, 200') in order to prevent the formation of loops (S) and/or circuits, so that preferably only one path connects the shielding elements (200, 200') to one another across layers.

11. Sensor device (10) according to any one of the preceding claims,
**characterized in that**
at least one through-plated hole (40) is provided in order to electrically connect at least one element, in particular the at least one shielding element (200) and/or at least one further shielding element (200') and/or the at least one antenna element (210) and/or the at least one edge sensor element (220), to one another across layers in the printed circuit board assembly (20) and thus to a common potential, at least one interruption (45) being provided as an adaptation (45) of at least one of the at least one element in order to prevent the formation of circuits and/or loops (S) by the connection.

12. Sensor device (10) according to any one of the preceding claims,
**characterized in that**
at least three or at least five or at least seven interruptions (45) are provided as an adaptation (45) to preferentially reduce interference at and/or by said at least one antenna element (210) to said printed circuit board assembly (20) and/or to provide decoupling of said at least one edge sensor element (220) from said at least one antenna element (210).

13. Sensor device (10) according to any one of the preceding claims,
**characterized in that**
the at least one edge sensor element (220) and/or the at least one shielding element (200) is respectively arranged adapted to the at least one antenna element (210), in particular substantially at a center point (211) of an antenna element (210) in a longitudinal direction (LR) of the printed circuit board assembly (20), comprises a connection tap (240) for an electrical connection to the processing device (60) to reduce an electrical influence by the antenna element (210),
and/or **in that** the at least one edge sensor element (220) and/or the at least one shielding element (200) is electrically connected to the processing device (60) via a respective connection tap (240) and via at least one decoupling resistor (R1, R2), a section between the connection tap (240) and the respective decoupling resistor (R1, R2) of the connection forming a disturbed conduction portion, wherein the respective decoupling resistor (R1, R2) is arranged at a maximum distance of 1 cm or at a maximum distance of 0.5 cm or at a maximum distance of 0.1 cm from the connection tap (240) to reduce the disturbed conduction portion of the connection.

14. Sensor device (10) according to any one of the preceding claims,
**characterized in that**
at least one of the at least one shielding element (200) and/or a further shielding element (200'), preferably on a same layer as the at least one edge sensor element (220), is formed as a passive shielding element (202),
and/or **in that** at least one active shielding element (201) is provided on the printed circuit board assembly (20), preferably on a layer (33) of the printed circuit board assembly (20) which is formed immediately adjacent to a layer (34) having a sensor element (230) for capacitive detection, in particular in order to provide shielding from an undesired region and/or surrounding region of the printed circuit board assembly (20) for the detection, and/or **in that** the at least one shielding element (200) and/or a further active shielding element (201) is designed for shielding from an undesired area for at least one capacitive detection, in particular of the at least one edge sensor element (220) and/or sensor element (230).

15. Door handle (2) for a vehicle (1) with a sensor device (10) according to one of the preceding claims.

## Revendications

1. Dispositif de détection (10) pour détecter une action d'activation sur un véhicule (1), en particulier pour une poignée de porte (2) du véhicule (1) :
- un ensemble de carte de circuit imprimé (20),
- au moins un dispositif de traitement (60) qui est disposé dans une zone centrale (265) de l'ensemble de carte de circuit imprimé (20),
- au moins un élément de détection de bord (220), qui est disposé dans une zone de bord (261, 262) adjacente à la zone centrale (265) de l'ensemble de carte de circuit imprimé (20) pour la détection capacitive, afin de fournir au moins partiellement la détection,
- au moins un élément de blindage (200) s'étendant entre ledit au moins un élément de détection de bord (220) et ladite zone centrale (265),
**caractérisé en ce qu'**au moins un élément d'antenne (210) est disposé au moins partiellement ou principalement dans une zone de bord (261, 262) de l'ensemble de carte de circuit imprimé (20) pour fournir une communication sans contact.

2. Dispositif de détection (10) selon la revendication 1,
**caractérisé en ce que**
l'au moins un élément de détection de bord (220) est réalisé sous la forme d'au moins un premier élément de détection de bord (221) et d'au moins un deuxième élément de détection de bord (222), le premier élément de détection de bord (221) respectif étant disposé dans une première zone de bord (261) de l'ensemble de carte de circuit imprimé (20) et le deuxième élément de détection de bord (222) respectif étant disposé dans une deuxième zone de bord (262) opposée à la première zone de bord (261), afin de fournir la détection pour des bords opposés (2.2, 2.3) de la poignée de porte (2),
et **en ce que** l'au moins un élément de détection de bord (220) est réalisé respectivement sous la forme d'une électrode allongée, en particulier sous la forme d'une piste conductrice de l'ensemble de carte de circuit imprimé (20.

3. Dispositif de détection (10) selon l'une des revendications précédentes,
**caractérisé en ce que**
l'ensemble de cartes de circuits imprimés (20) est réalisé sous la forme d'une carte de circuits imprimés multicouche (20), de sorte que l'ensemble de cartes de circuits imprimés (20) présente au moins deux ou au moins ou exactement quatre ou au moins six couches (31, 32, 33, 34), au moins deux (32, 33) des couches (31, 32, 33, 34) présentent chacune au moins un du au moins un élément de détection de bord (220), qui sont reliés électriquement entre eux au moins en partie par des contacts traversants (40), de préférence les au moins deux (32, 33) des couches (31, 32, 33, 34) présentant chacune un premier élément de détection de bord (221) et un deuxième élément de détection de bord (222).

4. Dispositif de détection (10) selon l'une des revendications précédentes,
**caractérisé en ce que**
le au moins un élément de blindage (200) s'étend entre le au moins un élément de détection de bord (220) et une électronique (65) dans la zone centrale (265) sur l'ensemble de carte de circuit imprimé (20), en particulier pour blinder le au moins un élément de détection de bord (220) de l'électronique (65) et/ou vice versa, de préférence l'électronique (65) étant disposée au moins partiellement sur une même couche (32, 33) avec l'élément de blindage (200) et au moins partiellement sur une couche (32, 33) différente du dispositif de traitement (60),
et/ou **en ce que** le au moins un élément de détection de bord (220) comprend plusieurs éléments de détection de bord (220), les éléments de détection de bord (220) étant découplés électriquement les uns des autres sur des zones de bord (261, 262) opposées de l'ensemble de carte de circuit imprimé (20), et étant reliés électriquement les uns aux autres sur des zones de bord (261, 262) identiques, en particulier également sur l'ensemble des couches par l'intermédiaire de contacts traversants (40) et/ou **en ce que**, pour chacun du au moins un élément de détection de bord (220), il est prévu un élément de blindage (200) associé qui s'étend au moins partiellement ou principalement parallèlement à l'élément de détection de bord (220) respectif.

5. Dispositif de détection (10) selon l'une des revendications précédentes,
**caractérisé en ce que**
au moins un élément de détection supplémentaire (230) pour la détection capacitive est disposé au moins partiellement à l'extérieur d'une zone de bord (261, 262) de l'ensemble de carte de circuit imprimé (20) sur l'ensemble de carte de circuit imprimé (20), de préférence sur une couche (34) de l'ensemble de carte de circuit imprimé (20) qui est différente d'une couche (32, 33) avec l'au moins un élément de détection de bord (220), afin de fournir de préférence la détection au moins partiellement dans une zone latérale (2.4) et/ou une zone centrale (2.5) de la poignée de porte (2).

6. Dispositif de détection (10) selon l'une des revendications précédentes,
**caractérisé en ce que**
l'au moins un élément d'antenne (210) est réalisé sous la forme d'une antenne NFC, et/ou **en ce que** l'au moins un élément d'antenne (210) est réalisé sur au moins une couche ou exactement deux couches (31, 32, 33, 34) de l'ensemble de carte de circuit imprimé (20), et s'étend de préférence le long de zones de bord (261, 262) opposées de la couche (31, 32, 33, 34), et s'étend de manière particulièrement préférée sur plusieurs couches (31, 32, 33, 34) en étant relié par au moins un contact traversant (40).

7. Dispositif de détection (10) selon l'une des revendications précédentes,
**caractérisé en ce que**
au moins un autre élément de blindage (200') est prévu, qui s'étend au moins partiellement entre l'élément d'antenne (210) et un bord (263) de l'ensemble de carte de circuit imprimé (20), afin de blinder en particulier l'élément d'antenne (210) d'un environnement de l'ensemble de carte de circuit imprimé (20) dans la zone de bord (261, 262) et/ou inversement,
et/ou **en ce qu'**une adaptation (45, 46, 47), notamment de l'au moins un élément de blindage (200) et/ou d'un autre élément de blindage (200') et/ou de l'au moins un élément de détection de bord (220), est prévue pour réduire une influence électrique et/ou une perturbation électrique d'au moins un élément d'antenne (210), notamment voisin de celui-ci, dans l'ensemble de carte de circuit imprimé (20).

8. Dispositif de détection (10) selon l'une des revendications précédentes,
**caractérisé en ce que**
une adaptation (45, 46, 47) de connexions électriques inter-couches de l'ensemble de carte de circuit imprimé (20) est prévue pour réduire les interférences au niveau du au moins un élément d'antenne (210) sur l'ensemble de carte de circuit imprimé (20).

9. Dispositif de détection (10) selon l'une des revendications précédentes,
**caractérisé en ce que**
une structure de grille (47) et/ou des fentes (46) de connexions électriques de l'ensemble de carte de circuit imprimé (20), notamment de l'au moins un élément de détection de bord (220), dépassant les positions, sont prévues sous la forme d'une adaptation (46, 47), de sorte qu'il est prévu de préférence plusieurs boucles redondantes (S) des connexions dépassant les positions et/ou que les fentes (46) sont réalisées sous la forme de plusieurs évidements des connexions, notamment du côté du bord, pour réduire de préférence les perturbations au niveau d'au moins un élément d'antenne (210) et/ou par ledit au moins un élément d'antenne (210) sur l'ensemble de carte de circuit imprimé (20) et/ou pour fournir un découplage dudit au moins un élément de détection de bord (220) dudit au moins un élément d'antenne (210).

10. Dispositif de détection (10) selon l'une des revendications précédentes,
**caractérisé en ce que**
au moins une interruption (45) de l'élément de blindage (200) et/ou d'un autre élément de blindage (200') et/ou de l'au moins un élément de détection de bord (220) est prévue en tant qu'adaptation (45), en particulier pour interrompre un circuit électrique et/ou une boucle (S) pour un courant, de préférence des courants de Foucault, induit par l'au moins un élément d'antenne (210) de l'ensemble de carte de circuit imprimé (20) et/ou **en ce qu'**une interruption (45) est prévue sous la forme d'une adaptation (45) dans la zone d'au moins un contact traversant (40), qui relie électriquement l'élément de blindage (200) d'une couche (32, 33) de l'ensemble de carte de circuit imprimé (20) à l'au moins un élément de blindage (200) et/ou à d'autres éléments de blindage (200') d'au moins une autre couche (31, 32, 33, 34) de l'ensemble de carte de circuit imprimé (20), afin d'interrompre une boucle (S) de cette liaison
et/ou **en ce qu'**au moins deux couches (32, 33) de l'ensemble de carte de circuit imprimé (20) présentent chacune un des au moins un élément de blindage (200), et de préférence au moins deux couches (31, 34) de l'ensemble de carte de circuit imprimé (20) présentent chacune un autre élément de blindage (200'), au moins un contact traversant (40) étant prévu pour relier électriquement les éléments de blindage (200, 200') entre eux, de sorte que les éléments de blindage (200, 200') reliés présentent un même potentiel électrique, au moins une interruption (45) étant prévue en tant qu'adaptation (45) d'au moins l'un des éléments de blindage (200, 200') afin d'empêcher la formation de boucles (S) et/ou de circuits électriques, de sorte que, de préférence, un seul chemin relie les éléments de blindage (200, 200') les uns aux autres en traversant les couches.

11. Dispositif de détection (10) selon l'une des revendications précédentes,
**caractérisé en ce que**
au moins un contact traversant (40) est prévu pour relier électriquement au moins un élément, en particulier l'au moins un élément de blindage (200) et/ou au moins un autre élément de blindage (200') et/ou l'au moins un élément d'antenne (210) et/ou l'au moins un élément de détection de bord (220), en passant par toutes les couches de l'ensemble de carte de circuit imprimé (20) et pour les mettre ainsi à un potentiel commun, au moins une interruption (45) étant prévue comme adaptation (45) d'au moins un de l'au moins un élément pour empêcher la formation de circuits électriques et/ou de boucles (S) par la liaison.

12. Dispositif de détection (10) selon l'une des revendications précédentes,
**caractérisé en ce que**
au moins trois ou au moins cinq ou au moins sept interruptions (45) sont prévues en tant qu'adaptation (45) pour réduire de préférence les interférences au niveau d'au moins un élément d'antenne (210) et/ou par ledit au moins un élément d'antenne (210) sur l'ensemble de carte de circuit imprimé (20) et/ou pour fournir un découplage dudit au moins un élément de détection de bord (220) dudit au moins un élément d'antenne (210).

13. Dispositif de détection (10) selon l'une des revendications précédentes,
**caractérisé en ce que**
le au moins un élément de détection de bord (220) et/ou le au moins un élément de blindage (200) est disposé respectivement de manière adaptée au au moins un élément d'antenne (210), en particulier sensiblement au niveau d'un point central (211) d'un élément d'antenne (210) dans une direction longitudinale (LR) de l'ensemble de carte de circuit imprimé (20), comprend une prise de connexion (240) pour une connexion électrique au dispositif de traitement (60) afin de réduire une influence électrique par l'élément d'antenne (210),
et/ou **en ce que** l'au moins un élément de détection de bord (220) et/ou l'au moins un élément de blindage (200) est relié électriquement au dispositif de traitement (60) par l'intermédiaire respectivement d'une prise de liaison (240) et par l'intermédiaire d'au moins une résistance de découplage (R1, R2), un tronçon entre la prise de liaison (240) et la résistance de découplage respective (R1, R2) de la connexion forme une section de ligne perturbée, la résistance de découplage respective (R1, R2) étant disposée au maximum à 1 cm ou au maximum à 0,5 cm ou au maximum à 0,1 cm de la prise de connexion (240) afin de réduire la section de ligne perturbée de la connexion.

14. Dispositif de détection (10) selon l'une des revendications précédentes,
**caractérisé en ce que**
au moins un de l'au moins un élément de blindage (200) et/ou un autre élément de blindage (200'), de préférence sur une même couche que l'au moins un élément de détection de bord (220), est conçu comme un élément de blindage passif (202),
et/ou **en ce qu'**au moins un élément de blindage actif (201) est prévu sur l'ensemble de carte de circuit imprimé (20), de préférence sur une couche (33) de l'ensemble de carte de circuit imprimé (20) qui est réalisée directement à proximité d'une couche (34) avec un élément de détection (230) pour la détection capacitive, afin de fournir en particulier un blindage par rapport à une zone non souhaitée et/ou une zone environnante de l'ensemble de carte de circuit imprimé (20) pour la détection,
et/ou **en ce que** l'au moins un élément de blindage (200) et/ou un autre élément de blindage actif (201) est réalisé pour le blindage d'une zone non souhaitée pour au moins une détection capacitive, en particulier de l'au moins un élément de détection de bord (220) et/ou élément de détection (230).

15. Poignée de porte (2) pour un véhicule (1) avec un dispositif de détection (10) selon l'une des revendications précédentes.
